# EUROPEAN PATENT SPECIFICATION

(11) **EP 4 180 828 B1**
(45) Date of publication and mention of the grant of the patent: **02.04.2025**
(21) Application number: 22201901.0
(22) Date of filing: 17.10.2022
(51) Int. Cl.: G01R 31/392

(54) **DETERIORATION DIAGNOSIS APPARATUS OF BATTERY AND DETERIORATION DIAGNOSIS METHOD OF BATTERY**
VORRICHTUNG ZUR DIAGNOSE DER VERSCHLECHTERUNG EINER BATTERIE UND VERFAHREN ZUR DIAGNOSE DER VERSCHLECHTERUNG EINER BATTERIE
APPAREIL DE DIAGNOSTIC DE DÉTÉRIORATION DE BATTERIE ET PROCÉDÉ DE DIAGNOSTIC DE DÉTÉRIORATION DE BATTERIE

(30) Priority: 15.11.2021 JP 2021185714
(43) Date of publication of application: 17.05.2023
(73) Proprietor: TOYOTA JIDOSHA KABUSHIKI KAISHA, Aichi-Ken 471-8571 (JP)
(72) Inventor: SUZUKI, Kentaro, Aichi-ken 471-8571 (JP); SATOH, Jun, Aichi-ken 471-8571 (JP); YAMADA, Koji, Osaka 563-8651 (JP)
(74) Representative: Kuhnen & Wacker Patent- und Rechtsanwaltsbüro PartG mbB

(56) References cited:
- WO-A1-2016/203655
- CN-A- 113 296 010
- JP-A- 2013 196 805
- US-A1- 2015 147 614

## Description

### BACKGROUND OF THE INVENTION

### 1. Field of the Invention

The present disclosure relates to a deterioration diagnosis apparatus of a battery and a deterioration diagnosis method of a battery.

### 2. Description of Related Art

An assembled battery includes a plurality of secondary batteries electrically connected to each other. By combining the secondary batteries, a large-capacity assembled battery can be obtained. However, a full charge capacity (an electricity amount accumulated in the secondary battery at a time of full charging) of a secondary battery decreases as the secondary battery deteriorates. For example, JP 2013-110906 A discloses a deterioration diagnosis method of a battery, which discharges an assembled battery until its voltage (a voltage between terminals) reaches a predetermined discharging end voltage, and estimates a deterioration degree of the assembled battery using data (a discharging curve) indicating a transition of the voltage of the assembled battery from a discharging start voltage to the discharging end voltage. A differential voltage analysis-based online evaluation method for the state of health (SOH) of a battery is known from CN 113 296 010 A. There, a delta V/delta Q curve is established, a tangent line of the delta V/delta Q curve is made through a certain delta V/delta Q value at the tail end of the delta V/delta Q curve, the slope of the tangent line is in linear negative correlation with the SOH value of the battery, and the larger the slope is, the smaller the SOH value of the battery is. From JP 2013-196805 A it is known that, in a lithium ion secondary battery system, when a start terminal battery voltage, an end terminal battery voltage, a start terminal SOC or an end terminal SOC in a charge/discharge cycle of a lithium ion secondary battery is detected or estimated as a singular point appearing on a Q-dV/dQ curve, the start terminal battery voltage, the end terminal battery voltage, the start terminal SOC or the end terminal SOC in the charge/discharge cycle of the lithium ion secondary battery is set to a battery voltage or an SOC avoiding the singular point appearing on the Q-dV/dQ curve. The technology disclosed by WO 2016/203655 A1monitors a storage battery by measuring the end voltage and electric current of a storage battery array formed by connecting in series-parallel a plurality of storage batteries, estimates the maximum number of failures of the storage batteries connected in parallel, and determines the available capacity of the storage battery array. This storage battery array failure diagnosis device is connected to an inverter device, and is provided with: a voltage sensor for measuring the end voltage of the storage battery array; an electric current sensor for measuring the electric current that flows to the storage battery array; an integrator for integrating electric current information that has been detected by the electric current sensor to determine the amount of electric charge; and a failure number estimation unit for determining the amount of electric charge at which the change in a value obtained by differentiating the end voltage by the amount of electric charge becomes slow, or the amount of electric charge at which a value obtained by differentiating the end voltage by the amount of charge twice becomes the minimum value, and estimating the maximum number of parallel failed batteries that have been cut off from the amount of charge. US 2015/146614 A1 finally discloses an apparatus that provides real-time monitoring of voltage and differential voltage of both anode and cathode in a battery configured with at least one reference electrode. There, voltage monitors are connected to a computer programmed for receiving anode voltage signals; receiving cathode voltage signals; calculating the derivative of the anode voltage with respect to time or with respect to capacity; and calculating the derivative of the cathode voltage with respect to time or with respect to capacity.

### SUMMARY OF THE INVENTION

In the deterioration diagnosis method of the battery described in JP 2013-110906 A, discharging is ended at a timing at which the voltage between the terminals of the assembled battery reaches the discharging end voltage during the discharging. In such a method, since voltages of some of the secondary batteries included in the assembled battery do not reach the discharging end voltage at the end of the discharging, it is difficult to estimate the deterioration degree of each secondary battery included in the assembled battery. Hereinafter, each secondary battery included in the assembled battery is referred to as a "cell".

Therefore, a deterioration diagnosis method of a battery, which ends the discharging at the timing at which voltages of all the cells included in the assembled battery reach the discharging end voltage, can be considered. However, in such a method, it is required that the discharging end voltage is set to an appropriate magnitude. When the discharging end voltage is too low, some cells included in the assembled battery may be over-discharged during the discharging. The over-discharging of a cell accelerates the deterioration of the cell. On the other hand, when the discharging end voltage is too high, sufficient data cannot be obtained during the discharging, and accuracy of estimating a deterioration degree (for example, a full charge capacity) of a cell may decrease.

The present disclosure provides a deterioration diagnosis apparatus of a battery and a deterioration diagnosis method of a battery that set a discharging end voltage to an appropriate magnitude, and estimate, with sufficient accuracy, a deterioration degree of each cell included in an assembled battery while restricting deterioration of a cell during discharging.

A deterioration diagnosis apparatus of a battery according to a first aspect of the present disclosure as set forth in claim 1 includes one or more processors. The one or more processors are configured to execute discharging of each of a plurality of cells included in an assembled battery while measuring a voltage of each of the cells, estimate a deterioration degree of each of the cells included in the assembled battery using voltage data indicating a transition of the voltage of each of the cells included in the assembled battery from a discharging start voltage to a predetermined discharging end voltage, and end the discharging when voltages of all the cells included in the assembled battery reach the predetermined discharging end voltage. The predetermined discharging end voltage is a cell voltage at which a change degree of the cell voltage per unit discharging amount starts to sharply rise while the cell voltage is dropping due to the discharging.

In the deterioration diagnosis apparatus of the assembled battery, since the discharging is continued until the voltages of all the cells included in the assembled battery reach the discharging end voltage, it is possible to estimate the deterioration degree of each cell included in the assembled battery using the voltage data indicating the transition of the voltage of each cell included in the assembled battery from the discharging start voltage to the discharging end voltage. Further, in the deterioration diagnosis apparatus of the assembled battery, as described below, the discharging end voltage is set to an appropriate magnitude. Hereinafter, the change degree (an absolute value) of the cell voltage per unit discharging amount is expressed by " |ΔV/ΔQ|". The discharging amount corresponds to a time integral value of a discharging current. The cell is a secondary battery composing the assembled battery. The assembled battery is composed of a plurality of cells electrically connected to each other.

The cell voltage drops during the discharging of the cell. At an initial stage of the discharging, |ΔV/ΔQ| is substantially constant. At a final stage of the discharging, |ΔV/ΔQ| sharply rises due to an increase in reaction resistance. Specifically, |ΔV/ΔQ| starts to sharply rise immediately after the cell voltage reaches a predetermined voltage (hereinafter, also referred to as "a voltage at a change point") during the discharging of the cell. Basically, the accuracy of the deterioration diagnosis becomes higher and the deterioration of the cell becomes easier as a period during which the discharging of the cell is continued is longer. Before |ΔV/ΔQ| starts to sharply rise, by continuing the discharging of the cell, a merit of improving the accuracy of the diagnosis is larger than a demerit of easy deterioration of the cell. On the other hand, after |ΔV/ΔQ| starts to sharply rise, by continuing the discharging of the cell, the demerit of easy deterioration of the cell is larger than the merit of improving the accuracy of the diagnosis. Therefore, by setting, as the discharging end voltage, the cell voltage at which the change degree of the cell voltage per unit discharging amount starts to sharply rise while the cell voltage is dropping due to the discharging, it is possible to promote both ensuring sufficient diagnostic accuracy and restricting deterioration of the cell. As such, with the above configuration, it is possible to estimate, with sufficient accuracy, the deterioration degree of each cell included in the assembled battery while restricting the deterioration of the cell during the discharging.

The voltage at the change point may be a cell voltage at which the change degree of the cell voltage per unit discharging amount is the lowest during the discharging. At the final stage of the discharging of the cell, |ΔV/ΔQ| tends to lower once and then starts to sharply rise. The discharging end voltage may be at or near the voltage at the change point (for example, a voltage slightly lower than the voltage at the change point).

In the first aspect, each of the cells included in the assembled battery may be a lithium-ion secondary battery. The predetermined discharging end voltage may be higher than a voltage at which an entire lithium site in a positive electrode active material of the lithium-ion secondary battery is occupied.

In the lithium-ion secondary battery, a lithium site exists in the positive electrode active material. The site is a crystallographically equivalent grid position. The presence of an atom at the grid position is expressed as occupying the site. The lithium site is a site occupied by lithium. Hereinafter, the voltage at which the entire the lithium site in the positive electrode active material of the lithium-ion secondary battery is occupied is also referred to as a "lithium occupying voltage". In a lithium-ion secondary battery (hereinafter, also referred to as a "ternary LIB") having a positive electrode of a layer-shaped crystal structure expressed by a general formula of LiₓNi_{y}Co_{z}Mn_{(1 - x - z)}, the lithium occupying voltage is 3.0 V.

When a deterioration degree of only one ternary LIB is estimated in an assembled battery including a plurality of ternary LIBs, the discharging of the assembled battery is ended at a timing at which a voltage of at least one ternary LIB included in the assembled battery reaches the discharging end voltage. In such a deterioration diagnosis apparatus of a battery, by setting the discharging end voltage to 3.0 V, it is possible to estimate, with sufficient accuracy, the deterioration degree of each cell included in the assembled battery while restricting the deterioration of the cell during the discharging.

On the other hand, in the deterioration diagnosis apparatus of the battery, when an assembled battery including a plurality of ternary LIBs is diagnosed, since the deterioration degree of each ternary LIB is estimated in the assembled battery including the ternary LIBs, the discharging of the assembled battery is continued until voltages of all the ternary LIBs included in the assembled battery reach the discharging end voltage. In such a deterioration diagnosis apparatus of a battery, 3.0 V is too low as the discharging end voltage. Therefore, in the above configuration, the discharging end voltage is set to be higher than the lithium occupying voltage.

In the first aspect, each of the cells included in the assembled battery may be a lithium-ion secondary battery having a positive electrode of a layer-shaped crystal structure expressed by a general formula of LiₓNi_{y}Co_{z}Mn_{(1 - x - z)}. The predetermined discharging end voltage may be 3.1 V or higher and 3.5 V or lower. With the above configuration, it is possible to estimate, with sufficient accuracy, the deterioration degree of each cell included in the assembled battery while restricting the deterioration of the cell during the discharging. In an embodiment in which each of the cells included in the assembled battery is a ternary LIB, the discharging end voltage may be 3.3 V or higher and 3.4 V or lower.

In the first aspect, each of the cells included in the assembled battery may be a lithium-ion secondary battery having a positive electrode of an olivine-shaped crystal structure expressed by a general formula of LiₓFePO₄. The predetermined discharging end voltage may be 2.0 V or higher and 3.2 V or lower. With the above configuration, it is also possible to estimate, with sufficient accuracy, the deterioration degree of each cell included in the assembled battery while restricting the deterioration of the cell during the discharging.

In the first aspect, the predetermined discharging end voltage may be a cell voltage at which the change degree of the cell voltage per unit discharging amount becomes a predetermined value or higher while the cell voltage is dropping due to the discharging. The one or more processors may be configured to determine whether the change degree of the cell voltage per unit discharging amount becomes the predetermined value or higher while the cell voltage is dropping due to the discharging of each cell included in the assembled battery, and, upon determining that the change degrees of the cell voltages per unit discharging amount of all the cells included in the assembled battery become the predetermined value or higher, end the discharging. Therefore, the one or more processors may be configured to, upon determining that the change degrees of the cell voltages per unit discharging amount of all the cells included in the assembled battery are the predetermined value or higher, end the discharging.

The one or more processors can determine, based on whether |ΔV/ΔQ| becomes the predetermined value or higher while the cell voltage is dropping due to the discharging, whether |ΔV/ΔQ| has started to sharply rise. With the above configuration, it is easy to end the discharging of the cell when |ΔV/ΔQ| starts to sharply rise while the cell voltage is dropping due to the discharging. The predetermined value is set such that the cell voltage at which |ΔV/ΔQ| becomes the predetermined value or higher while the cell voltage is dropping due to the discharging becomes the cell voltage at which |ΔV/ΔQ| starts to sharply rise while the cell voltage is dropping due to the discharging.

In the first aspect, the assembled battery may be mounted on a vehicle. The one or more processors may be configured to estimate the deterioration degree of the assembled battery using a usage history of the vehicle, and change the predetermined discharging end voltage such that the predetermined discharging end voltage becomes higher as the estimated deterioration degree of the assembled battery is higher.

The cell voltage at which |ΔV/ΔQ| starts to sharply rise while the cell voltage is dropping due to the discharging tends to gradually rise as the battery deteriorates. With the above configuration, it is possible to finely adjust the discharging end voltage according to a change in the cell voltage at which |ΔV/ΔQ| starts to sharply rise. The one or more processors may finely adjust the discharging end voltage within a change width of, for example, 0.1 V. Examples of parameters indicating the usage history of the vehicle can include an integrated mileage of the vehicle, an input/output power amount (an integrated value) of the assembled battery, the number of times that the assembled battery is charged and discharged, and a period of use of the assembled battery (for example, an elapsed time from the start of use). The one or more processors can roughly determine the deterioration degree of the assembled battery (for example, large deterioration / medium deterioration / small deterioration) using usage history information of the vehicle.

In the first aspect, all the cells included in the assembled battery may be connected in series. The one or more processors may be configured to maintain a current value during the discharging of each of the cells.

With the above configuration, it is easy to match the current value during the discharging of each cell included in the assembled battery. As such, it is easy to estimate, with high accuracy, the deterioration degree of the assembled battery.

In the first aspect, the assembled battery may be configured to supply power to an in-vehicle power load. The one or more processors may be configured to execute the discharging by controlling the in-vehicle power load.

With the above configuration, it is possible to easily and appropriately execute the deterioration diagnosis of the assembled battery for the vehicle. The in-vehicle power load that is controlled by the one or more processors during the discharging may include at least one of air conditioning equipment, a seat heater, and a lighting device.

A deterioration diagnosis apparatus of a battery according to a second aspect of the present disclosure as set forth in claim 9 includes a storage device and one or more processors. The storage device is configured to manage a discharging end voltage indicating a timing of ending discharging of the battery. The discharging of the battery is executed to acquire data for estimating a deterioration degree of the battery. The one or more processors are configured to store, in the storage device, as the discharging end voltage, a voltage of the battery when a change degree of a voltage per unit discharging amount of the battery after a start of the discharging of the battery becomes a predetermined value or higher. The one or more processors are configured to store the discharging end voltagen association with information indicating the type of the battery. The one or more processors are configured to acquire, from the storage device, the discharging end voltage corresponding to the type of the battery using the information indicating the type of the battery, and discharge the battery based on the discharging end voltage.

With the above configuration, it is possible to manage an appropriate discharging end voltage. The deterioration diagnosis apparatus of the battery can provide an appropriate discharging end voltage to a device (a discharging device) that executes the discharging of the battery to acquire the data for estimating the deterioration degree of the battery. Alternatively, the deterioration diagnosis apparatus of the battery may execute the discharging of the battery by itself to acquire the data for estimating the deterioration degree of the battery. By discharging the battery based on the appropriate discharging end voltage, it is possible to estimate, with sufficient accuracy, the deterioration degree of the battery while restricting the deterioration degree of the battery during the discharging. More specifically, when the voltages of all the cells included in the assembled battery reach the discharging end voltage, by ending the discharging of the assembled battery, it is possible to estimate, with sufficient accuracy, the deterioration degree of each cell included in the assembled battery while restricting the deterioration of the cells during the discharging. The storage device manages the discharging end voltage in association with a type of the battery. The type of the battery may be distinguished using at least one of a battery manufacturer, a model number, and a serial number.

A deterioration diagnosis method of a battery according to a third aspect of the present disclosure as set forth in claim 10 is executed by one or more processors. The deterioration diagnosis method includes executing discharging of each of a plurality of cells included in an assembled battery while measuring a voltage of each of the cells, ending the discharging when the voltages of all the cells included in the assembled battery reach a predetermined discharging end voltage, and estimating a deterioration degree of each of the cells included in the assembled battery using voltage data indicating a transition of the voltage of each of the cells included in the assembled battery from a discharging start voltage to the predetermined discharging end voltage. The predetermined discharging end voltage is a cell voltage at which a change degree of the cell voltage per unit discharging amount starts to sharply rise while the cell voltage is dropping due to the discharging.

With the above deterioration diagnosis method of the assembled battery, in the same manner as the deterioration diagnosis apparatus described above, it is also possible to estimate, with sufficient accuracy, the deterioration degree of each cell included in the assembled battery while restricting the deterioration of the cell during the discharging.

The deterioration of the assembled battery may be diagnosed while the assembled battery is mounted on the vehicle. The vehicle may include an internal combustion engine and a motor (hereinafter, also referred to as a "first motor") that executes start processing of the internal combustion engine. The assembled battery of which the deterioration is diagnosed may be mounted on the vehicle and configured to supply power to the first motor. Hereinafter, the internal combustion engine mounted on the vehicle may be referred to as an "engine". The engine may be configured to generate traveling driving power. In addition to the first motor, the vehicle may further include a second motor that receives supply of power from the assembled battery and generates traveling driving power. The first motor may be configured to generate power using drive power output from the engine and supply the generated power to the assembled battery. The start processing of the internal combustion engine is processing for starting the internal combustion engine. The internal combustion engine can be started by receiving assistance from the motor. The start processing may be cranking. The cranking is to start the internal combustion engine by rotating a crankshaft of the internal combustion engine.

A full charge capacity of the assembled battery in an initial state may be 5 kWh or smaller. When a capacity of the assembled battery is 5 kWh or smaller, a diagnosis with sufficient throughput can be executed by the above-described deterioration diagnosis method using discharging. The full charge capacity of the assembled battery to be diagnosed in the initial state may be 0.1 kWh or larger and 5 kWh or smaller, or 0.3 kWh or larger or 3 kWh or smaller. The assembled battery to be diagnosed may be a drive battery mounted on a hybrid electric vehicle (HEV).

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram illustrating a configuration of a vehicle according to an embodiment of the present disclosure;
FIG. 2 is a diagram illustrating a configuration of a deterioration diagnosis apparatus of a battery according to the embodiment of the present disclosure;
FIG. 3 is a flowchart illustrating a deterioration diagnosis method of the battery according to the embodiment of the present disclosure;
FIG. 4 is a graph illustrating an example of a discharging characteristic of a cell included in an assembled battery illustrated in FIG. 2;
FIG. 5 is a graph for describing an issue that may arise when a discharging lower limit voltage is set as a discharging end voltage;
FIG. 6 is a graph for describing a merit of raising the discharging end voltage;
FIG. 7 is a graph for describing a demerit of raising the discharging end voltage;
FIG. 8 is a graph for describing a method of deciding the discharging end voltage in the embodiment of the present disclosure;
FIG. 9 is a graph illustrating a discharging characteristic of a lithium-ion secondary battery (a ternary LIB);
FIG. 10 is a graph illustrating a relationship between the discharging end voltage and a coverage ratio;
FIG. 11 is a flowchart illustrating a method of setting the discharging end voltage according to a modified example of the embodiment of the present disclosure;
FIG. 12 is a flowchart illustrating a modified example of processes illustrated in FIG. 3;
FIG. 13 is a graph for describing a method of setting a threshold value used in processes illustrated in FIG. 12;
FIG. 14 is a diagram illustrating a modified example of a service tool illustrated in FIG. 2;
FIG. 15 is a flowchart illustrating processes related to data acquisition executed by the service tool illustrated in FIG. 14;
FIG. 16 is a flowchart for describing a method of setting the discharging end voltage based on the data that is acquired using the processes illustrated in FIG. 15;
FIG. 17 is a diagram illustrating a modified example of a vehicle control device illustrated in FIG. 2; and
FIG. 18 is a diagram illustrating a modified example of the assembled battery illustrated in FIG. 2.

### DETAILED DESCRIPTION OF EMBODIMENTS

Embodiments of the present disclosure will be described in detail with reference to drawings. In the drawings, the same or corresponding parts are denoted by the same reference signs and the description thereof will not be repeated. Hereinafter, an electronic control unit is also referred to as an "ECU".

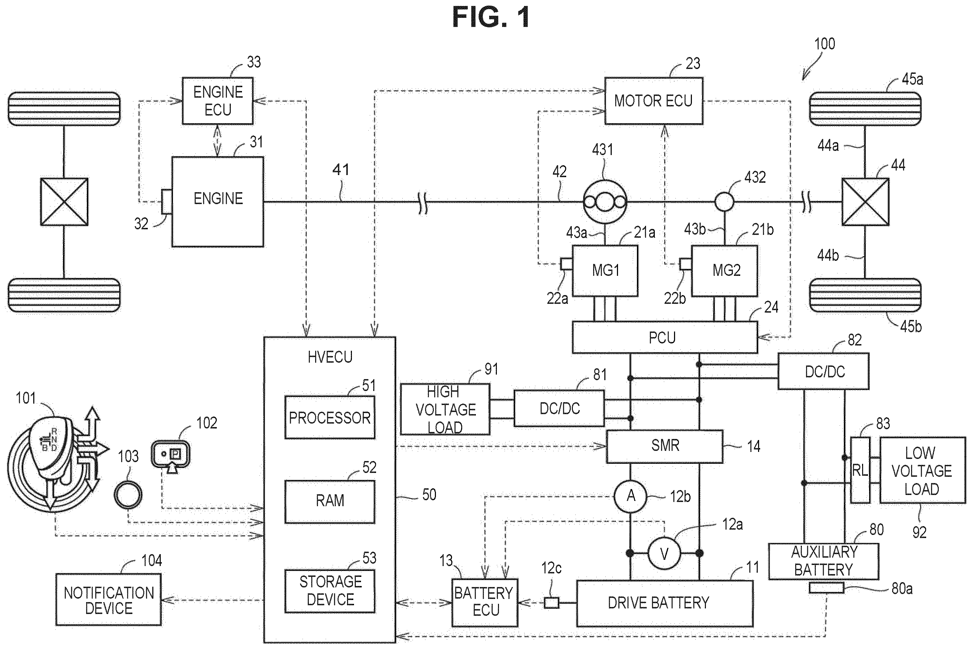

FIG. 1 is a diagram illustrating a configuration of a vehicle according to an embodiment. With reference to FIG. 1, a vehicle 100 is a hybrid electric vehicle (HEV). In this embodiment, it is assumed that the vehicle is a front-wheel drive four-wheel vehicle (more specifically, an HEV), but the number of wheels and a drive system can be appropriately changed. For example, the drive system may be four-wheel drive.

The vehicle 100 includes a drive battery 11, a voltage sensor 12a, a current sensor 12b, a temperature sensor 12c, a system main relay (SMR) 14, a first motor generator 21a (hereinafter, referred to as an "MG 21a"), a second motor generator 21b (hereinafter, referred to as an "MG 21b"), a power control unit (PCU) 24, and an engine 31.

The drive battery 11 includes a rechargeable secondary battery. The drive battery 11 is configured to supply power to the PCU 24 (and thus the MGs 21a, 21b). In this embodiment, an assembled battery including a plurality of secondary batteries that are electrically connected to each other is employed as the drive battery 11. A full charge capacity of the drive battery 11 in an initial state may be, for example, approximately 1.5 kWh. The secondary batteries included in the drive battery 11 may be modularized by a predetermined number. The assembled battery may be composed by combining a plurality of modules. The number of secondary batteries included in the drive battery 11 may be 10 or more and less than 100, or may be 100 or more. In this embodiment, the number of secondary batteries included in the drive battery 11 is approximately 50. The drive battery 11 is assembled in a form of a battery pack on, for example, a floor panel of the vehicle 100. In this embodiment, the battery pack is formed by installing accessories (a voltage sensor 12a, a current sensor 12b, a temperature sensor 12c, a battery ECU 13, an SMR14, and the like) in a battery case that accommodates the drive battery 11.

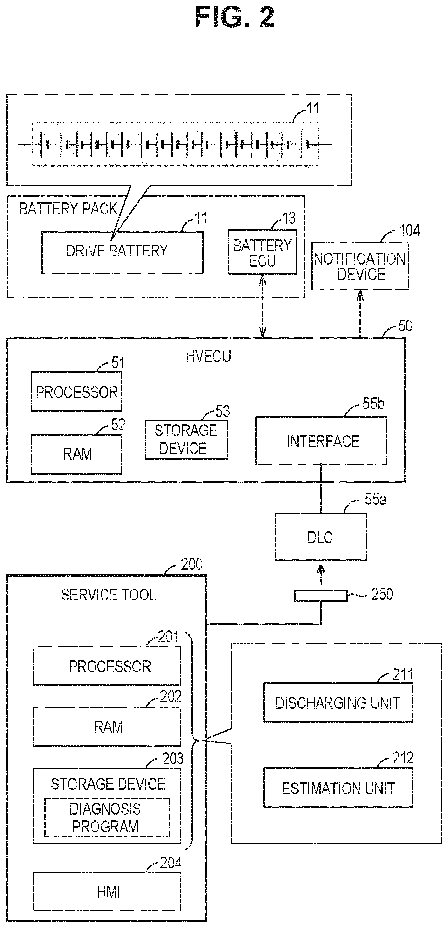

Each secondary battery included in the assembled battery is referred to as a "cell". In this embodiment, all the cells included in the assembled battery are connected in series (see, for example, FIG. 2 described below). In this embodiment, a lithium-ion secondary battery (a ternary LIB) having a positive electrode (a ternary positive electrode) of a layer-shaped crystal structure expressed by a general formula of LiₓNi_{y}Co_{z}Mn_{(1 - x - z)} is employed as a cell. However, examples of the cell are not limited to the lithium-ion secondary battery, and may include other secondary batteries (for example, a nickel-hydrogen battery). Further, an all-solid-state secondary battery may be employed as a cell. Examples of the form of assembling the drive battery 11 in the vehicle 100 are not limited to the battery pack, and may include a packless form.

The voltage sensor 12a detects a voltage of each cell of the drive battery 11. The current sensor 12b detects current flowing through the drive battery 11. The temperature sensor 12c detects a temperature of each cell of the drive battery 11. Each sensor outputs a detection result to the battery ECU 13. The battery ECU 13 calculates a State of Charge (SOC) of each cell and an SOC of the drive battery 11 using the detection result of each sensor. The SOC indicates a remaining accumulated power amount and represents a ratio of, for example, a current accumulated power amount to an accumulated power amount in a fully charged state from 0% to 100%. The current sensor 12b is provided in a current path of the drive battery 11. In this embodiment, one voltage sensor 12a and one temperature sensor 12c are provided to each cell.

The SMR 14 is configured to switch between connection / disconnection of the current path that connects the PCU 24 to the drive battery 11. As the SMR 14, for example, an electromagnetic mechanical relay can be employed. When the SMR 14 is in a closed state (a connected state), power can be sent and received between the drive battery 11 and the PCU 24. On the other hand, when the SMR 14 is in an open state (a disconnected state), the current path that connects the drive battery 11 to the PCU 24 is disconnected. The SMR 14 is controlled by an HVECU 50. The SMR 14 is switched to the closed state when, for example, the vehicle 100 is traveling.

Each of the MGs 21a and 21b is a motor generator that has both a function as a motor that outputs torque by receiving supply of driving power and a function as a generator that generates generated power by receiving torque. As each of the MGs 21a and 21b, an alternating current motor (for example, a permanent magnet type synchronous motor or an induction motor) is used. Each of the MGs 21a and 21b is electrically connected to the drive battery 11 via the PCU 24. The MGs 21a, 21b have rotor shafts 43a, 43b, respectively. The rotor shafts 43a, 43b correspond to rotation shafts of the MGs 21a, 21b, respectively.

The vehicle 100 further includes a single pinion type planetary gear 431. An output shaft 41 of the engine 31 is connected to the planetary gear 431. As the engine 31, any internal combustion engine can be employed, but in this embodiment, as the engine 31, a spark-ignition type internal combustion engine including a plurality of cylinders (for example, four cylinders) is employed. The engine 31 generates drive power by combusting fuel (for example, gasoline) in each cylinder, and rotates a crankshaft (not shown) common to all cylinders using the generated drive power. The crankshaft of the engine 31 is connected to the output shaft 41 via a torsional damper (not shown). As the crankshaft rotates, the output shaft 41 also rotates. An example of the engine 31 is not limited to a gasoline engine, and may include a diesel engine or a hydrogen engine.

The output shaft 41 of the engine 31 is connected to an input shaft 42 of the planetary gear 431. The planetary gear 431 has three rotating elements, that is, an input element, an output element, and a reaction force element. More specifically, the planetary gear 431 has a sun gear, a ring gear coaxially arranged with the sun gear, a pinion gear that meshes with the sun gear and the ring gear, and a carrier that holds the pinion gear such that it can rotate and revolve. The carrier corresponds to the input element, the ring gear corresponds to the output element, and the sun gear corresponds to the reaction force element. The input shaft 42 of the planetary gear 431 is connected to the carrier.

The rotor shaft 43a of the MG 21a is connected to the sun gear of the planetary gear 431. Torque is input from the engine 31 to the carrier of the planetary gear 431. The planetary gear 431 is configured to divide and transfer the torque output by the engine 31 to the sun gear (and thus the MG 21a) and the ring gear. When the torque output by the engine 31 is output to the ring gear, a reaction force torque output by the MG 21a acts on the sun gear.

The planetary gear 431 and MG 21b are configured to combine drive power output from the planetary gear 431 (that is, drive power output to the ring gear) and drive power output from the MG 21b (that is, drive power output to the rotor shaft 43b) and transfer the combined power to drive wheels 45a, 45b. More specifically, an output gear (not shown) that meshes with the driven gear 432 is installed at the ring gear of the planetary gear 431. Further, a drive gear (not shown) installed at the rotor shaft 43b of the MG 21b also meshes with the driven gear 432. The driven gear 432 acts to combine torque output by the MG 21b to the rotor shaft 43b with torque output from the ring gear of the planetary gear 431. The drive torque combined as above is transferred to a differential gear 44, and further transferred to the drive wheels 45a, 45b via the drive shafts 44a, 44b extending to the right and left from the differential gear 44.

A transmission mechanism (not shown) may be provided on a downstream side of the planetary gear 431 (for example, between the driven gear 432 and the differential gear 44). The transmission mechanism includes a clutch and a brake, and is configured to change a gear ratio (that is, a ratio of rotation speed of an input shaft of the transmission mechanism to rotation speed of an output shaft of the transmission mechanism) depending on a state (engagement / disengagement) of each of the clutch and the brake. The vehicle 100 may further include a hydraulic pressure circuit (not shown) that supplies hydraulic pressure to each of the clutch and the brake included in the transmission mechanism. The HVECU 50 may switch the state (engagement / disengagement) of each of the clutch and the brake included in the transmission mechanism by controlling the hydraulic pressure circuit. The transmission mechanism may be positioned on the upstream side (for example, between the engine 31 and the planetary gear 431) of a power split device (the planetary gear 431).

The vehicle 100 further includes a shift lever 101 and a P position switch 102. Each of the shift lever 101 and the P position switch 102 is configured to be able to switch between shift ranges according to a shift operation of a user. The user can select any of a neutral (N) range, a reverse (R) range, a drive (D) range, and a brake (B) range by moving the shift lever 101 to a predetermined position. Further, the user can select a parking (P) range by stopping the vehicle 100 and pressing the P position switch 102. The HVECU 50 switches the shift range of the vehicle 100 to a range selected by the user. The HVECU 50 controls the hydraulic pressure circuit according to, for example, the shift range.

The vehicle 100 further includes a battery ECU 13, a motor ECU 23, an engine ECU 33, and an HVECU 50. In this embodiment, a computer (for example, a microcomputer) is employed as each of the battery ECU 13, the motor ECU 23, the engine ECU 33, and the HVECU 50. The ECUs are connected to each other in a manner capable of executing CAN communication therebetween.

The HVECU 50 includes a processor 51, a random access memory (RAM) 52, and a storage device 53. As the processor 51, for example, a central processing unit (CPU) can be employed. The RAM 52 functions as a working memory that temporarily stores data processed by the processor 51. The storage device 53 is configured to be able to retain the stored information. In addition to the program, the storage device 53 stores information (for example, a map, a mathematical formula, and various parameters) used in the program. When the processor 51 executes the program stored in the storage device 53, various processes are executed in the HVECU 50.

Although FIG. 1 illustrates a detailed configuration of only the HVECU 50, each of the other ECUs also includes a processor, a RAM, and a storage device. The number of processors included in each ECU is arbitrary, and any ECU may include a plurality of processors. Further, various processes in each ECU are not limited to execution by software, and may be executed by dedicated hardware (an electronic circuit).

Motor sensors 22a, 22b that detect states (for example, current, a voltage, a temperature, and rotation speed) of the MGs 21a, 21b are provided in the MGs 21a, 21b, respectively. Each of the motor sensors 22a, 22b outputs a detection result to the motor ECU 23. An engine sensor 32 that detects a state (for example, an air intake amount, air intake pressure, an air intake temperature, exhaust pressure, an exhaust temperature, a catalyst temperature, an engine coolant temperature, and rotation speed) of the engine 31 is provided in the engine 31. The engine sensor 32 outputs a detection result to the engine ECU 33. The HVECU 50 receives detection values of the motor sensors 22a, 22b and the engine sensor 32 from the motor ECU 23 and the engine ECU 33, as necessary. Further, the HVECU 50 receives a state (for example, a cell voltage, current, a temperature, and an SOC) of the drive battery 11 from the battery ECU 13, as necessary.

The vehicle 100 includes a monitoring unit 80a that detects a state of an auxiliary battery 80 described below. The monitoring unit 80a includes various sensors that detect a state (for example, a temperature, current, and a voltage) of the auxiliary battery 80, and outputs a detection result to the HVECU 50. The HVECU 50 can acquire the state (for example, the temperature, current, the voltage, and an SOC) of the auxiliary battery 80 based on an output of the monitoring unit 80a. Further, although not shown, other sensors (for example, a vehicle speed sensor, a fuel gauge, an odometer, an accelerator operation amount sensor, and an atmospheric pressure sensor) that indicate a situation of the vehicle 100 are also mounted on the vehicle 100. The HVECU 50 can grasp information of the vehicle 100 based on outputs of various sensors (in-vehicle sensors) mounted on the vehicle 100.

The HVECU 50 is configured to output a command (a control command) for controlling the engine 31 to the engine ECU 33. The engine ECU 33 is configured to control various actuators (for example, a throttle valve, an ignition device, and an injector) (none of them shown) of the engine 31 according to the command from the HVECU 50. The HVECU 50 can control the engine through the engine ECU 33.

The HVECU 50 is configured to output a command (a control command) for controlling each of the MG 21a and the MG 21b to the motor ECU 23. The motor ECU 23 is configured to generate a current signal (for example, a signal indicating a magnitude and frequency of current) corresponding to a target torque of each of the MG 21a and the MG21b according to the command from the HVECU 50, and to output the generated current signal to the PCU 24. The HVECU 50 can control the motors through the motor ECU 23.

The PCU 24 includes, for example, two inverters (not shown) provided to correspond to the MGs 21a, 21b, and a converter (not shown) arranged between each inverter and the drive battery 11. The PCU 24 is configured to supply power accumulated in the drive battery 11 to each of the MG 21a and the MG 21b, and to supply power generated by each of the MG 21a and the MG 21b to the drive battery 11. The PCU 24 is configured to be able to separately control the states of the MGs 21a, 21b, that is, for example, it can turn the MG 21b to a power running state while turning the MG 21a to a power generation state.

The MG 21a is configured to execute start processing of the engine 31. Specifically, when the engine 31 is started, the MG 21a that receives supply of power from the drive battery 11 executes cranking of the engine 31.

The MG 21a is configured to generate power (that is, engine power generation) using drive power output from the engine 31. The HVECU 50 charges the drive battery 11 with power generated by the engine power generation such that the SOC of the drive battery 11 does not become excessively low while the vehicle 100 is traveling. Further, the drive battery 11 is also charged with power generated by regenerative braking by the MG 21b.

The vehicle 100 is configured to execute HV traveling and EV traveling. The HV traveling is executed by the engine 31 and the MG 21b while the engine 31 is generating traveling driving power. The EV traveling is executed by the MG 21b when the engine 31 is in a stopped state. When the engine 31 is in the stopped state, combustion in each cylinder is not executed. When the combustion in each cylinder is stopped, combustion energy (and thus traveling driving power) is not generated in the engine 31.

The vehicle 100 further includes an auxiliary battery 80, DC/DC converters 81, 82, an auxiliary relay 83, a high voltage load 91, and a low voltage load 92. The full charge capacity of the auxiliary battery 80 is smaller than that of the drive battery 11. A full charge capacity of a battery is an electricity amount accumulated in the battery in a fully charged state and decreases as the battery deteriorates. As the auxiliary battery 80, for example, a lead battery can be employed. However, as the auxiliary battery 80, a secondary battery (for example, a nickel-hydrogen battery) other than the lead battery may be employed. The DC/DC converters 81, 82, the auxiliary relay 83, the high voltage load 91, and the low voltage load 92 are controlled by the HVECU 50. The HVECU 50 may control these through the battery ECU 13.

The high voltage load 91 is an auxiliary machine of a high voltage system. The low voltage load 92 is an auxiliary machine of a low voltage system. A drive voltage of the low voltage load 92 is lower than a drive voltage of the high voltage load 91. The auxiliary battery 80 is an in-vehicle battery of the low voltage system (for example, a 12 V system), and is configured to supply power to the low voltage load 92. In this embodiment, the high voltage load 91 includes air conditioning equipment and the low voltage load 92 includes a lighting device. The air conditioning equipment is configured to heat and cool a cabin of the vehicle 100. The lighting device includes a lighting device that illuminates the inside of the vehicle and a lighting device (for example, a headlight) that illuminates the outside of the vehicle. At least one of the high voltage load 91 and the low voltage load 92 may further include a seat heater that heats a seat of the vehicle 100.

The DC/DC converter 81 is provided between the drive battery 11 and the high voltage load 91, steps down power supplied from the drive battery 11 and outputs it to the high voltage load 91. The DC/DC converter 82 steps down power supplied from the drive battery 11 and outputs it to each of the auxiliary battery 80 and the low voltage load 92. When the SMR 14 is in the open state (the disconnected state), power of the drive battery 11 is not supplied to any of the high voltage load 91, the low voltage load 92, and the auxiliary battery 80. An auxiliary relay 83 is arranged in a current path that connects the DC/DC converter 82 to the low voltage load 92. When the auxiliary relay 83 is in the open state (the disconnected state), power is not supplied to the low voltage load 92.

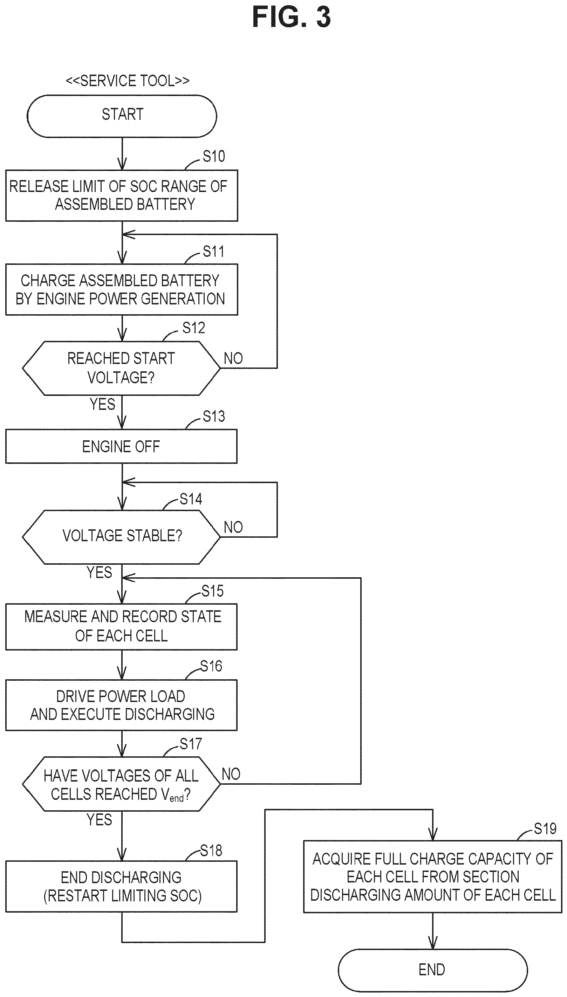

When the SMR 14 is in the closed state (the connected state), power can be supplied from the drive battery 11 to the auxiliary battery 80 through the DC/DC converter 82. For example, when the SOC of the auxiliary battery 80 is lower than a predetermined value, the HVECU 50 charges the auxiliary battery 80 with power of the drive battery 11. Further, the HVECU 50 drives the high voltage load 91 and the low voltage load 92 using power of the drive battery 11 according to an instruction from a service tool 200 (see FIG. 2) in the deterioration diagnosis of the assembled battery (see S16 in FIG. 3) described below. At this time, the HVECU 50 controls the SMR 14, the DC/DC converters 81, 82, and the auxiliary relay 83 such that power of the drive battery 11 is supplied to each of the high voltage load 91 and the low voltage load 92.

The HVECU 50 is configured to execute an SOC limit control to the drive battery 11. The SOC limit control is a control for limiting the SOC of the drive battery 11 to within a predetermined SOC range. The HVECU 50 limits an input / output of the drive battery 11 such that the SOC of the drive battery 11 does not leave the SOC range. Specifically, the HVECU 50 controls the MGs 21a, 21b, the engine 31, and the DC/DC converters 81, 82 such that the SOC of the drive battery 11 is within the SOC range. The SOC range is variably set depending on a state of the vehicle 100. The HVECU 50 may set an SOC range for protecting the drive battery 11 and its peripheral parts using, for example, a map stored in the storage device 53.

The vehicle 100 further includes a power switch 103. The power switch 103 is used for switching between start / stop of a vehicle system (the HVECU 50 and the like). The power switch 103 is operated by the user.

The vehicle 100 further includes a notification device 104. The notification device 104 is configured to send a notification to the user of the vehicle 100 in response to a request from the HVECU 50. Examples of the notification device 104 can include a meter panel, a head-up display, a navigation display, a warning light, or a speaker. The notification device 104 may function as an input device that receives an input from the user. The notification device 104 may include a touch panel display or a smart speaker that receives a voice input. The notification device 104 may be mounted on a portable device (that is, an electronic device that can be carried by the user), such as a tablet terminal, a smartphone, or a wearable device.

FIG. 2 is a diagram illustrating a configuration of a deterioration diagnosis apparatus of a battery according to this embodiment. With reference to FIG. 2 together with FIG. 1, in this embodiment, the service tool 200 functions as a deterioration diagnosis apparatus of a battery. The service tool 200 includes a computer including a processor 201, a RAM 202, and a storage device 203. The storage device 203 stores a diagnosis program. The deterioration diagnosis method (see FIG. 3 described below) of the battery according to this embodiment is executed when the processor 201 executes the diagnosis program stored in the storage device 203.

The service tool 200 further includes a human machine interface (HMI) 204. The HMI 204 includes an input device and a display device. The HMI 204 may be a touch panel display. The HMI 204 may include a smart speaker that receives a voice input.

The HVECU 50 further includes a data link connector (DLC) 55a and an interface 55b of the DLC 55a. The DLC 55a is a connector that can be connected to a connector 250 of the service tool 200, and is arranged in, for example, the vicinity of a driver seat of the vehicle 100. The service tool 200 is an external diagnosis machine used by, for example, a worker (such as a mechanic) in a maintenance shop to grasp a state of a vehicle. Examples of the service tool 200 can include a general scan tool (GST). By connecting the connector 250 of the service tool 200 to the DLC 55a, the service tool 200 can read vehicle data stored in the storage device 53.

In the deterioration diagnosis method of the battery according to this embodiment, the service tool 200 discharges each cell while measuring a voltage of each cell included in the drive battery 11 (the assembled battery). Then, when the voltages of all the cells included in the drive battery 11 reach a predetermined discharging end voltage (hereinafter, referred to as "V_{end}"), the service tool 200 ends the discharging. After ending the discharging, the service tool 200 estimates a deterioration degree of each cell included in the drive battery 11, using voltage data indicating a transition of the voltage of each cell included in the drive battery 11 from a discharging start voltage to V_{end}.

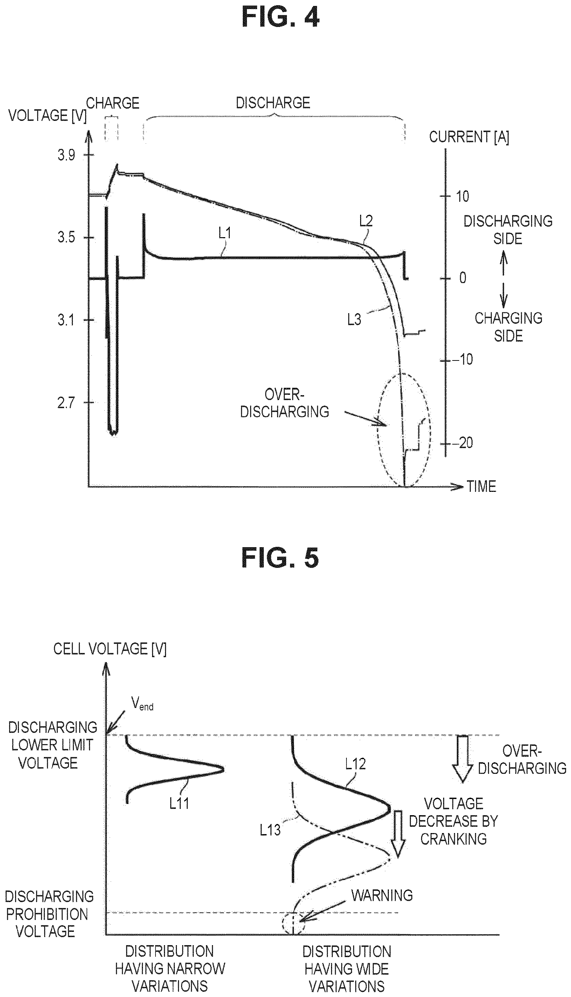

However, when V_{end} is too low, some cells included in the assembled battery may be over-discharged during the discharging of the assembled battery. On the other hand, when the V_{end} is too high, sufficient data cannot be obtained during the discharging of the assembled battery, and accuracy of estimating a deterioration degree (for example, a full charge capacity) of a cell may decrease. Therefore, in the deterioration diagnosis method of the battery according to this embodiment, the cell voltage, at which |ΔV/ΔQ| (that is, the change degree of the cell voltage per unit discharging amount) starts to sharply rise while the cell voltage is dropping due to the discharging, is set as V_{end}. A method of deciding V_{end} and a technical significance thereof will be described below (see FIGS. 5 to 10 described below).

The service tool 200 according to this embodiment includes a discharging unit 211 and an estimation unit 212. The discharging unit 211 is configured to discharge each cell while measuring the voltage of each cell included in the drive battery 11 mounted on the vehicle 100, and to end the discharging when the voltages of all the cells included in the assembled battery reach V_{end}. The estimation unit 212 is configured to estimate a deterioration degree of each cell included in the assembled battery using the voltage data indicating the transition of the voltage of each cell included in the assembled battery from the discharging start voltage to V_{end}.

FIG. 3 is a flowchart illustrating the deterioration diagnosis method of the battery according to this embodiment. Processes illustrated in this flowchart are executed when, for example, a predetermined instruction is input from the user to the HMI 204 after the connector 250 of the service tool 200 is connected to the DLC 55a of the vehicle 100 in a parked state. However, a condition of starting the process illustrated in FIG. 3 is not limited thereto, and can be arbitrarily set. Hereinafter, each step in the flowchart is simply referred to as "S". The discharging unit 211 of the service tool 200 transmits a control command to the HVECU 50, whereby S10 to S18 of FIG. 3 are executed.

With reference to FIG. 3 together with FIGS. 1 and 2, in S10, the service tool 200 releases an SOC range related to the SOC limit control. As such, the SOC limit (the SOC limit control) of the drive battery 11 becomes invalid.

Subsequently in S11, the service tool 200 drives the engine 31 and charges the drive battery 11 with power generated by the engine power generation. By the process of S11, power generated by the MG 21a using drive power output from the engine 31 is input to the drive battery 11 via the PCU 24 and the SMR 14.

In S12, the service tool 200 determines whether the voltages of all the cells included in the drive battery 11 have become a predetermined start voltage (hereinafter, referred to as "Vₛₜₐᵣₜ") or higher. The voltage of each cell included in the drive battery 11 is measured by the voltage sensor 12a. Vₛₜₐᵣₜ may be a cell voltage indicating that the cell has turned to the fully charged state, or may be a charging upper limit voltage of the cell. The charging upper limit voltage corresponds to an upper limit of a recommended voltage range. When the charging of the cell is continued until the voltage exceeds the charging upper limit voltage, the cell may be over-charged. The over-charging accelerates the deterioration of the cell. Vₛₜₐᵣₜ may be 3.6 V or higher and 3.9 V or lower, or may be approximately 3.6 V. Further, the service tool 200 may determine whether the voltages of all the cells included in the drive battery 11 have become Vₛₜₐᵣₜ or higher based on the SOC of the drive battery 11. For example, when the SOC of the drive battery 11 has become a predetermined SOC value (for example, 70%) or higher, the service tool 200 may determine that the voltages of all the cells included in the drive battery 11 have become Vₛₜₐᵣₜ or higher.

The processes of S11 and S12 are repeated until the voltages of all the cells included in the drive battery 11 become Vₛₜₐᵣₜ or higher (NO in S12). When the voltages of all the cells become Vₛₜₐᵣₜ or higher (YES in S12), in S13, the service tool 200 stops the engine 31. Thereafter, in S14, the service tool 200 determines whether the voltages of all the cells included in the drive battery 11 have become stable. The process stands by in S14 until the voltage of each cell included in the drive battery 11 becomes stable, and, when the voltage of each cell included in the drive battery 11 becomes stable (YES in S14), the process proceeds to S15.

In S15, the service tool 200 measures a state (a voltage, current, and a temperature) of each cell included in the drive battery 11, and records a measurement result in the storage device 203. Subsequently in S16, the service tool 200 discharges the drive battery 11 by controlling a power load of the vehicle 100. The drive battery 11 is configured to supply power to the power load mounted on the vehicle 100.

Specifically, in S16, the service tool 200 controls the power load (for example, at least one of the high voltage load 91 and the low voltage load 92) of the vehicle 100 such that discharging current of each cell included in the drive battery 11 becomes a predetermined value (hereinafter, referred to as "Vd"). In this embodiment, the air conditioning equipment (the high voltage load 91) and the lighting device (the low voltage load 92) are driven by power supplied from the drive battery 11. The service tool 200 adjusts power supplied from the drive battery 11 to the high voltage load 91 and the low voltage load 92, using the DC/DC converters 81, 82, respectively. Then, the service tool 200 maintains a current value during the discharging of each cell included in the drive battery 11. Vd may be 1 A or higher and 10 A or lower, or may be approximately 5 A. In this embodiment, the current value during the discharging of each cell is maintained at Vd. In this embodiment, Vd is set to a fixed value (for example, 5 A), but Vd may be variable depending on the situation.

In S17, the service tool 200 determines whether the voltages of all the cells included in the drive battery 11 have reached a predetermined discharging end voltage (V_{end}).

FIG. 4 is a graph illustrating an example of a discharging characteristic of the cell included in the drive battery 11. Each of the lines L1 to L3 in FIG. 4 illustrates an example of a transition of current and a voltage of the drive battery 11 (the assembled battery) when S10 to S16 of FIG. 3 are executed, and the discharging (S16) is continued for a predetermined time. The line L1 illustrates a transition of current of the drive battery 11. The lines L2, L3 respectively illustrate the discharging characteristics (more specifically, the transitions of the cell voltages during the discharging) of a first cell and a second cell included in the drive battery 11. A full charge capacity of the first cell is larger than that of the second cell.

With reference to FIG. 4, in a comparison between the transition of a voltage of the first cell (the line L2) and the transition of a voltage of the second cell (the line L3), the voltage of the second cell starts to decrease earlier than that of the first cell and decreases to a voltage lower than a voltage to which the voltage of the first cell decreases. As such, the cell voltage tends to easily decrease during the discharging as a full charge capacity is smaller. When the voltage of the cell decreases too much due to the discharging of the cell, the deterioration of the cell is accelerated. The fact that the discharging of the voltage of the cell is continued until it decreases too much is referred to as "over-discharging".

Hereinafter, with reference to FIGS. 5 to 9, the method of deciding the discharging end voltage (V_{end}) will be described. FIG. 5 is a graph for describing an issue that may arise when a discharging lower limit voltage is set as V_{end}. In FIG. 5, a line L11 illustrates a voltage distribution of all cells included in a first assembled battery (hereinafter, referred to as a "first cell voltage distribution"). A line L12 illustrates a voltage distribution of all cells included in a second assembled battery (hereinafter, referred to as a "second cell voltage distribution"). The second cell voltage distribution (the line L12) has wider variations on cell voltages than the first cell voltage distribution (the line L11). The first cell voltage distribution and the second cell voltage distribution are distributions when the discharging is continued until the voltages of all the cells included in the first assembled battery and all the cells included in the second assembled battery reach the discharging lower limit voltage (V_{end}), respectively.

In FIG. 5, the discharging lower limit voltage corresponds to a lower limit value of the recommended voltage range. When the discharging of the cell is continued until the voltage falls below the discharging lower limit voltage, the deterioration of the cell may be accelerated. The fact that the discharging of the cell is continued until the deterioration of the cell may be accelerated corresponds to the above-described "over-discharging". A discharging prohibition voltage corresponds to a dischargeable limit value. When the discharging of the cell is continued until the voltage falls below the discharging prohibition voltage, an abnormality (for example, malfunction or failure) may occur in the cell. In the vehicle 100 according to this embodiment, the HVECU 50 has a warning flag for self-diagnosis (OBD) in the storage device 53, and when a voltage of any of the cells included in the drive battery 11 falls below the discharging prohibition voltage, the HVECU 50 is configured to raise the warning flag (for example, a value of the flag is changed from "0" to "1"). The discharging lower limit voltage and the discharging prohibition voltage of each cell included in the drive battery 11 according to this embodiment are 3.0 V and 1.6 V, respectively.

With reference to FIG. 5, in the deterioration diagnosis apparatus of the assembly battery in which the discharging lower limit voltage is set as V_{end}, when the variations on cell voltages are wide (see, for example, the line L12), the deterioration of some cells included in the assembly battery may excessively progress and the life of the assembly battery may be shortened. Further, when the engine cranking is executed by power supplied by the assembled battery, the voltages of the entire assembled battery decrease as illustrated by a line L13. As such, the voltages of some cells included in the assembled battery may fall below the discharging prohibition voltage, and the warning flag may be raised.

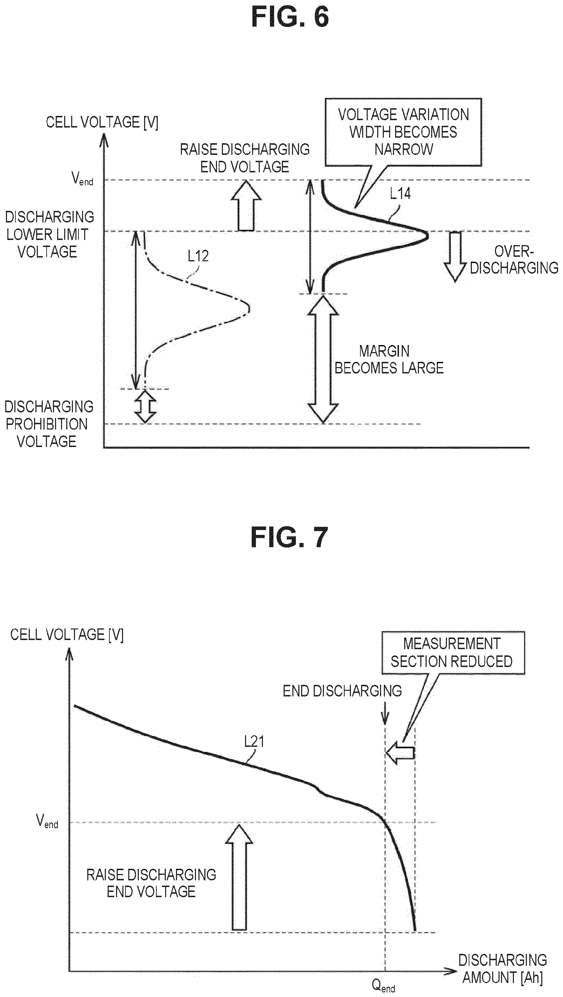

FIG. 6 is a graph for describing a merit of raising V_{end}. A line L12 in FIG. 6 is the same as the line L12 in FIG. 5. A line L14 in FIG. 6 illustrates the second cell voltage distribution at the end of the discharging in the embodiment where V_{end} is set to a voltage higher than the discharging lower limit voltage.

With reference to FIG. 6, by raising V_{end} to a voltage higher than the discharging lower limit voltage (see, for example, the line L14), a margin from the discharging prohibition voltage becomes large, and the warning flag is less likely to be raised. Further, the number of cells in an over-discharged state is reduced. For this reason, the shortening of the life of the assembled battery is restricted, and a voltage shortage of the assembled battery at the time of engine cranking is restricted. Further, a variation width of cell voltages tends to become wider as a discharging period is longer. Thus, by raising V_{end}, the variation width of the cell voltages becomes narrow.

FIG. 7 is a graph for describing a demerit of raising V_{end}. A line L21 in FIG. 7 illustrates an example of a transition of the voltages of the cells included in the drive battery 11 during the discharging. The transition of the voltage during the discharging is slightly different for each cell, but the tendency is substantially the same.

With reference to FIG. 7, when the discharging of the cell is started, the cell voltage gradually decreases. ΔV/ΔQ (corresponding to a slope of the graph), which is a value obtained by differentiating the cell voltage (the vertical axis) with respect to the discharging amount (the horizontal axis), is substantially constant immediately after the start of the discharging, but becomes high on the negative side when the discharging is continued for a while. In the deterioration diagnosis method of the assembled battery according to this embodiment, voltage data (that is, data indicating the transition of the cell voltage) of each cell included in the assembled battery during a discharging period (a period from the start of the discharging to the end of the discharging) is acquired and the deterioration degree of each cell is estimated based on the voltage data. "Q_{end}" in FIG. 7 illustrates the discharging amount (the discharging amount at the end of the discharging) corresponding to V_{end}. When V_{end} is raised, a discharging end timing becomes earlier and the discharging period becomes shorter. When the discharging period becomes shorter, the number of pieces of the voltage data for the deterioration diagnosis of the assembled battery is reduced, and the accuracy of estimating the deterioration degree of the cell decreases.

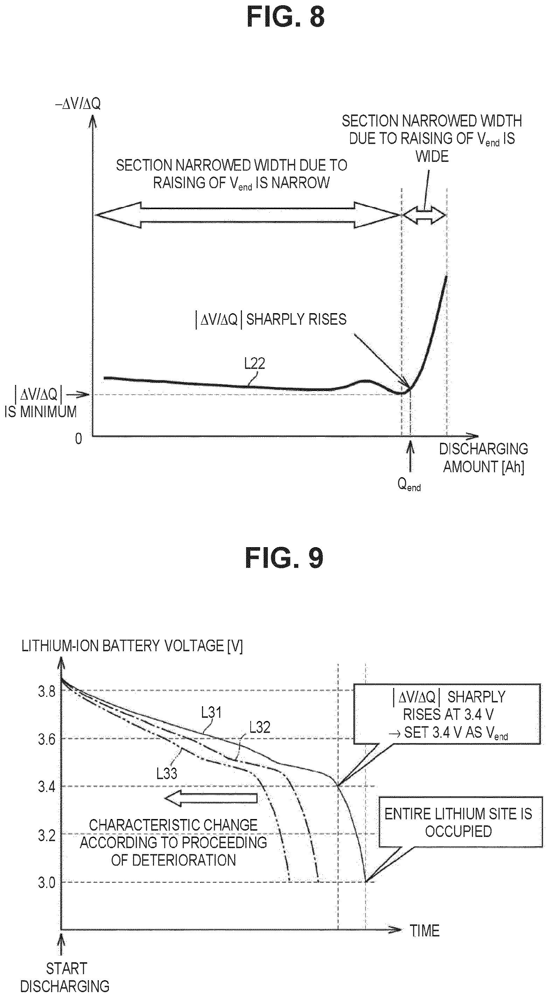

FIG. 8 is a graph for describing the method of deciding V_{end}. The vertical axis of the graph represents -ΔV/ΔQ, and the horizontal axis represents the discharging amount. Since the cell voltage decreases as the discharging amount is increased, ΔV/ΔQ becomes a negative value and -ΔV/ΔQ becomes a positive value. -ΔV/ΔQ indicates the change degree of the cell voltage per unit discharging amount. -ΔV/ΔQ has the same value as |ΔV/ΔQ|. A line L22 in FIG. 8 illustrates an example of a transition of -ΔV/ΔQ of the cells included in the drive battery 11 during the discharging. The transition of -ΔV/ΔQ during the discharging is slightly different for each cell, but the tendency is substantially the same.

With reference to FIG. 8, at an initial stage of the discharging of the cell, -ΔV/ΔQ is substantially constant. Thereafter, at a final stage of the discharging, -ΔV/ΔQ sharply rises due to the increase in reaction resistance. At the final stage of the discharging of the cell, -ΔV/ΔQ lowers once, passes through the cell voltage (the voltage at the change point) at which -ΔV/ΔQ becomes the lowest during the discharging, and then starts to sharply rise. A narrowed width (more specifically, a narrowed width of the discharging period per the raised voltage) of the discharging period due to the raising of V_{end} becomes wider as -ΔV/ΔQ becomes higher. Before |ΔV/ΔQ| starts to sharply rise, a merit of raising V_{end} is larger than a demerit of raising V_{end}. After |ΔV/ΔQ| starts to sharply rise, the demerit of raising V_{end} is larger than the merit of raising V_{end}. In the deterioration diagnosis method of the battery according to this embodiment, the cell voltage at which -ΔV/ΔQ (that is, the change degree of the cell voltage per unit discharging amount) starts to sharply rise while the cell voltage is dropping due to the discharging is set as V_{end}. Such V_{end} may be obtained in advance by experiments or simulation. In the examples illustrated in FIGS. 7 and 8, the length of the discharging period is expressed by the discharging amount, but the length of the discharging period may be expressed by time.

FIG. 9 is a graph illustrating a discharging characteristic of a lithium-ion secondary battery. Lines L31, L32, and L33 in FIG. 9 respectively illustrate transitions of the voltages during the discharging of a first lithium-ion secondary battery (hereinafter, referred to as a "first LIB"), a second lithium-ion secondary battery (hereinafter, referred to as a "second LIB"), and a third lithium-ion secondary battery (hereinafter, referred to as a "third LIB"). The first to third LIBs are lithium-ion secondary batteries (more specifically, ternary LIBs) having different deterioration degrees from each other, in order of the third LIB (deterioration degree: high), the second LIB (deterioration degree: intermediate), and the first LIB (deterioration degree: low) from the battery having the highest deterioration degree.

With reference to FIG. 9, in a case where the lithium-ion secondary battery employed as each cell of the drive battery 11 in this embodiment has been discharged, |ΔV/ΔQ | starts to sharply rise when the voltage of the lithium-ion secondary battery has become 3.4 V. For this reason, in the deterioration diagnosis method of the battery according to this embodiment, 3.4 V is set as V_{end}. In the lithium-ion secondary battery, the voltage at which the entire lithium site in the positive electrode active material is occupied is 3.0 V. In other words, V_{end} is set to a voltage higher than the voltage at which the entire lithium site in the positive electrode active material in the lithium-ion secondary battery (the cell) is occupied. As such, the discharging is ended before the entire lithium site in the positive electrode active material is occupied.

The discharging characteristic of the lithium-ion secondary battery changes (see lines L31 to L33) as the lithium-ion secondary battery deteriorates. However, the battery voltage (the voltage of the lithium-ion secondary battery) at which |ΔV/ΔQ | starts to sharply rise during the discharging of the lithium-ion secondary battery does not significantly change even when the deterioration of the lithium-ion secondary battery progresses. In the example illustrated in FIG. 9, a change width is within 0.1 V.

As described above, in this embodiment, 3.4 V is set as V_{end}. With reference to FIG. 3 again, together with FIGS. 1 and 2, while a voltage of any of the cells included in the drive battery 11 is higher than V_{end} (NO in S17), the processes of S15 to S17 are repeated, and the discharging of the drive battery 11 is continued. Then, when the voltages of all the cells included in the drive battery 11 become V_{end} or lower (YES in S17), in S18, the service tool 200 ends the discharging of the drive battery 11.

After ending the discharging of the drive battery 11 in S18, the service tool 200 restarts the SOC limit control. As such, the SOC of the drive battery 11 is limited to within the predetermined SOC range, again.

By repeating the above-described processes of S15 to S17, data indicating the state (particularly, the deterioration degree) of the drive battery 11 is recorded in the storage device 203 of the service tool 200. After the discharging is ended in S18, subsequently in S19, the estimation unit 212 of the service tool 200 estimates the deterioration degree of each cell included in the drive battery 11 using the recorded data of the drive battery 11.

Specifically, the service tool 200 acquires a section discharging amount (Ah) from the discharging start voltage to V_{end} (the discharging end voltage) of each cell using the data (including the voltage data indicating the transition of the cell voltage from the discharging start voltage to the discharging end voltage) acquired in S15. The discharging amount corresponds to a time integral value of a discharging current (A). When the discharging current fluctuates within a section, the section discharging amount can be obtained by integrating the discharging current for each unit time with respect to time. When the discharging current is constant within the section, a value obtained by multiplying the discharging current (A) by the discharging period (h) corresponds to the discharging amount.

As described above, the service tool 200 calculates the section discharging amount (that is, the section discharging amount from the discharging start voltage to V_{end}) of the cell and converts the section discharging amount into the full charge capacity using a predetermined map. A map illustrating a relationship between a temperature of the cell, the section discharging amount, and the full charge capacity may be used to obtain the full charge capacity of the cell. When the temperature of the cell and the section discharging amount are given to the map, the full charge capacity of the cell is output from the map. The temperature of the cell that is used may be the average temperature during the discharging or the temperature at the start of the discharging. The map may be stored in the storage device 203 in advance. The map may be a map common to all the cells included in the drive battery 11. The service tool 200 may acquire the map from an external server (for example, a server that manages information on various batteries), or may acquire the map from the vehicle 100.

As described above, in S19, the estimation unit 212 of the service tool 200 estimates the full charge capacity of each cell included in the drive battery 11. The full charge capacity (the electricity amount accumulated in the cell at a time of full charging) of the cell indicates the deterioration degree of the cell. The deterioration degree of the cell becomes higher as the full charge capacity of the cell is smaller. When the process of S19 is executed, a series of processes illustrated in FIG. 3 ends.

After the processes illustrated in FIG. 3, the service tool 200 may transmit a diagnosis result (that is, information indicating the full charge capacity of each cell included in the drive battery 11) to the vehicle 100. The diagnosis result received by the vehicle 100 may be stored in the storage device 53 of the HVECU 50. The notification device 104 may send a notification of the diagnosis result in response to a request from the user.

After the processes illustrated in FIG. 3, the HVECU 50 may start the engine 31 by the above-described cranking and charge the drive battery 11 with power generated by the engine power generation. The HVECU 50 may return the SOC of the drive battery 11 to the SOC value before the diagnosis. Alternatively, the HVECU 50 may charge the drive battery 11 until the vehicle 100 turns to a state of being capable of EV traveling.

As described above, the deterioration diagnosis method of the battery according to this embodiment includes the series of processes illustrated in FIG. 3.

In the processes illustrated in FIG. 3, each cell is discharged while the voltage of each of the cells included in the assembled battery (the drive battery 11) is measured, and the discharging is ended when the voltages of all the cells included in the assembled battery reach the predetermined discharging end voltage (V_{end}) (S15 to S18). The discharging end voltage (V_{end}) is the cell voltage (for example, 3.4 V) at which |ΔV/ΔQ | (that is, the change degree of the cell voltage per unit discharging amount) starts to sharply rise while the cell voltage is dropping due to the discharging (see FIGS. 7 and 8). In the processes illustrated in FIG. 3, the deterioration degree of each cell included in the assembled battery (the drive battery 11) is estimated using the voltage data indicating the transition of the voltage of each cell included in the assembled battery from the discharging start voltage to the discharging end voltage (V_{end}) (S19).

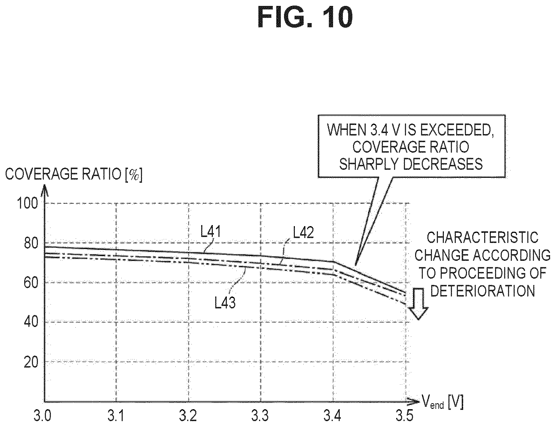

FIG. 10 is a graph illustrating a relationship between the discharging end voltage (V_{end}) and a coverage ratio. Lines L41, L42, and L43 in FIG. 10 respectively illustrate the coverage ratio when the deterioration diagnosis of the above-described first LIB, second LIB, and third LIB has been executed by the processes illustrated in FIG. 3. Specifically, the coverage ratio is measured while the discharging end voltage (V_{end}) is changed in the range from 3.0 V to 3.5 V. The coverage ratio corresponds to a ratio of the section discharging amount to the full charge capacity. The coverage ratio is obtained by dividing the section discharging amount calculated in S19 of FIG. 3 by the full charge capacity. The coverage ratio can be expressed as a percentage. The deterioration degrees of the batteries are in order of the third LIB (deterioration degree: high), the second LIB (deterioration degree: intermediate), and the first LIB (deterioration degree: low) from the highest.

With reference to FIG. 10, when V_{end} is raised above 3.4 V, the coverage ratio sharply decreases (see lines L41 to L43). In the deterioration diagnosis method where V_{end} is 3.4 V, the coverage ratio is approximately 70%, and the deterioration degree of the cell (the ternary LIB) can be estimated with sufficient accuracy. Further, by raising V_{end} to 3.4 V, the deterioration of the cell (the ternary LIB) during the discharging is restricted (see FIG. 6). As such, with the deterioration diagnosis method of the battery according to the embodiment, it is possible to estimate, with sufficient accuracy, the deterioration degree of each cell included in the assembled battery while restricting the deterioration of the cell during the discharging.

With the deterioration diagnosis method of the battery, the full charge capacity of each cell included in the assembled battery (the drive battery 11) is acquired. For this reason, it is possible to rebuild the assembled battery by replacing only the cell having a high deterioration degree from among the cells in the assembled battery. However, the present disclosure is not limited thereto, and a battery pack including the drive battery 11 may be replaced. Whether the assembled battery needs replacing may be determined based on the full charge capacity of a cell having the minimum capacity (a cell having the smallest full charge capacity in the assembled battery).

In the embodiment, 3.4 V is set as the discharging end voltage (V_{end}). However, the discharging end voltage is not limited thereto, and can be appropriately changed. For example, in an embodiment where each of the cells included in the assembled battery (the drive battery 11) is a lithium-ion secondary battery (an LFP cell) having a positive electrode (a cobalt-free iron phosphate positive electrode) of an olivine-shaped crystal structure expressed by a general formula of LiₓFePO₄, a voltage selected from a range from 2.0 V or higher and 3.2 V or lower may be set as the discharging end voltage. With the above discharging end voltage, it is also possible to estimate, with sufficient accuracy, the deterioration degree of each cell included in the assembled battery while restricting the deterioration of the cell during the discharging. Further, in the deterioration diagnosis method of the battery according to the embodiment, the discharging end voltage (V_{end}) is a fixed value (3.4 V). However, the present disclosure is not limited thereto, and the discharging unit 211 may be configured to estimate the deterioration degree of the drive battery 11 using the usage history of the vehicle 100, and change V_{end} such that V_{end} becomes higher as the estimated deterioration degree of the drive battery 11 is higher.

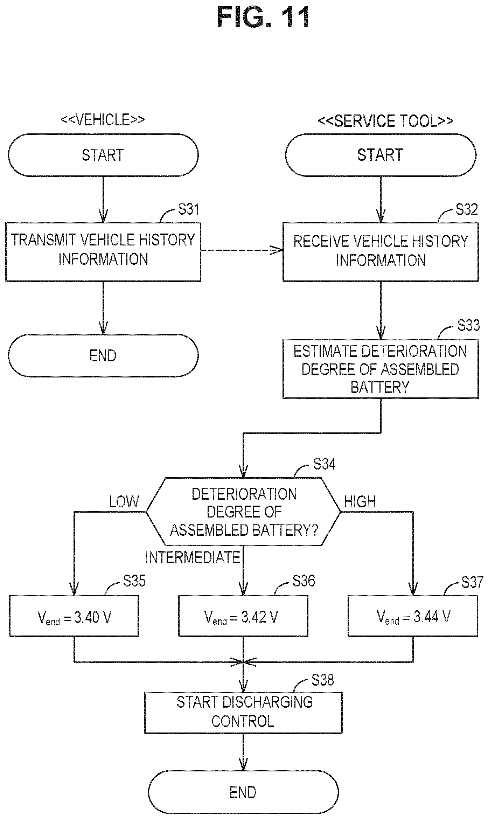

FIG. 11 is a flowchart illustrating a method of setting the discharging end voltage according to a modified example. The processes illustrated in this flowchart are executed before the process illustrated in FIG. 3 is started. For example, when a predetermined instruction is input to the HMI 204 from the user after the connector 250 of the service tool 200 is connected to the DLC 55a of the vehicle 100 in the parked state, the processes illustrated in FIG. 11 are executed. Then, the process illustrated in FIG. 3 is started by a process of S38 described below.

With reference to FIG. 11 together with FIGS. 1 and 2, in S31, the HVECU 50 transmits vehicle history information (that is, information indicating the usage history of the vehicle 100) to the service tool 200. The vehicle history information is sequentially acquired by various sensors mounted on the vehicle 100 when the user is using the vehicle 100, and is stored in the storage device 53. In one example, the vehicle history information transmitted in S31 includes the integrated mileage of the vehicle 100.

In S32, the service tool 200 receives the vehicle history information. Thereafter, the discharging unit 211 of the service tool 200 executes the processes of S33 to S38 described below.

In S33, the service tool 200 estimates the deterioration degree of the drive battery 11 using the vehicle history information. Specifically, it is estimated that the deterioration degree of the drive battery 11 becomes higher as the integrated mileage of the vehicle 100 is longer. Subsequently, in S34, the service tool 200 determines whether the deterioration degree of the drive battery 11 is high, intermediate, or low.

When the estimated deterioration degree of the drive battery 11 is low ("low" in S34), in S35, the service tool 200 sets 3.40 V as the discharging end voltage (V_{end}). When the estimated deterioration degree of the drive battery 11 is approximately intermediate ("intermediate" in S34), in S36, the service tool 200 sets 3.42 V as the discharging end voltage (V_{end}). When the estimated deterioration degree of the drive battery 11 is high ("high" in S34), in S37, the service tool 200 sets 3.44 V as the discharging end voltage (V_{end}).

When any of the processes S35 to S37 is executed, in S38, the service tool 200 generates a discharging control start trigger used for the deterioration diagnosis of the assembled battery. As such, the process illustrated in FIG. 3 is started.

As such, according to the processes illustrated in FIG. 11, V_{end} is changed such that V_{end} becomes higher as the estimated deterioration degree of the drive battery 11 is higher. With such an embodiment, it is possible to finely adjust the discharging end voltage (V_{end}) in accordance with the cell voltage (see FIGS. 9 and 10) at which |ΔV/ΔQ| starts to sharply rise, the cell voltage at which |ΔV/ΔQ| starts to sharply rise being changed depending on the deterioration degree of the drive battery 11.

The processes illustrated in FIG. 3 may be appropriately changed. For example, the discharging end voltage (V_{end}) may be the cell voltage at which the change degree of the cell voltage per unit discharging amount while the cell voltage is dropping due to the discharging becomes a predetermined value or higher. Then, the discharging unit 211 may be configured to determine whether |ΔV/ΔQ| has become the predetermined value or higher while the cell voltage is dropping due to the discharging of each cell included in the assembled battery, and end the discharging upon determining that |ΔV/ΔQ| of all the cells included in the assembled battery has become the predetermined value or higher.

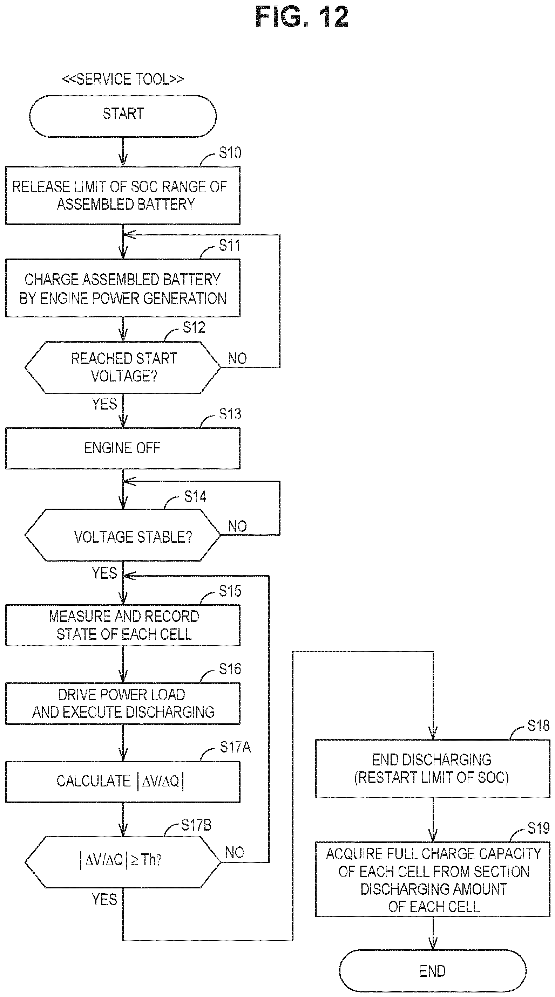

FIG. 12 is a flowchart illustrating a modified example of the processes illustrated in FIG. 3. The processes illustrated in FIG. 12 are equivalent to the processes illustrated in FIG. 3, except that S17A and S17B are employed instead of S17 (FIG. 3). Hereinafter, the processes illustrated in FIG. 12 will be described, focusing on differences from those illustrated in FIG. 3.

With reference to FIG. 12, together with FIGS. 1 and 2, in S17A, the service tool 200 calculates |ΔV/ΔQ| of each cell by differentiating the cell voltage with respect to the discharging amount in the transition of the voltage mapped (plotted) during the discharging of each cell. In S17B, the service tool 200 determines whether |ΔV/ΔQ| of all the cells included in the drive battery 11 has become a predetermined value (hereinafter, referred to as "Th") or higher.

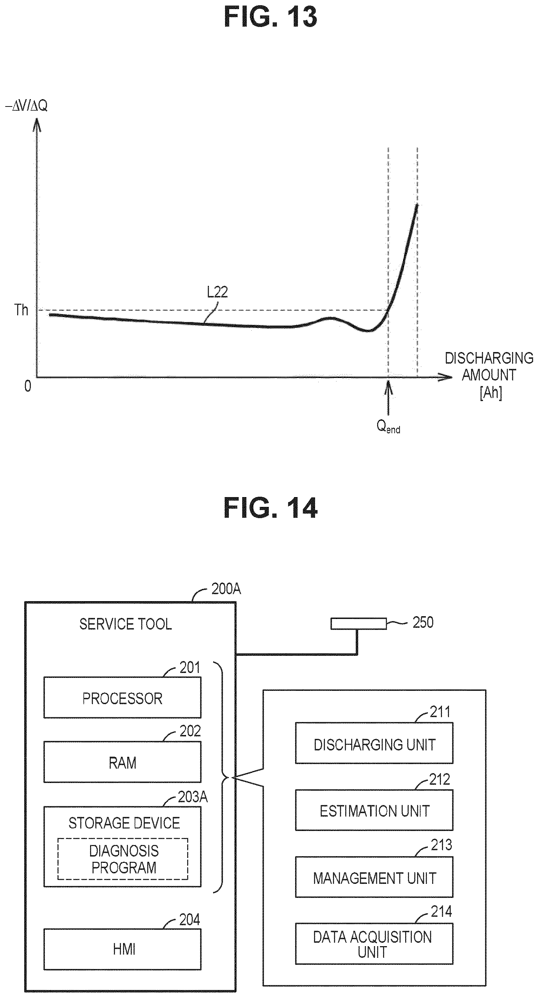

FIG. 13 is a graph for describing a method of setting Th. A line L22 in FIG. 13 is the same as the line L22 in FIG. 8. As illustrated in FIG. 13, Th is set such that the cell voltage at which |ΔV/ΔQ| becomes Th or higher while the cell voltage is dropping due to the discharging becomes the cell voltage at which |ΔV/ΔQ| starts to sharply rise while the cell voltage is dropping due to the discharging.

While |ΔV/ΔQ| of any of the cells included in the drive battery 11 is lower than Th, the service tool 200 makes a negative determination in S17B of FIG. 12, repeats the processes of S15 to S17B, and continues the discharging of the drive battery 11. Then, when |ΔV/ΔQ| of all the cells included in the drive battery 11 becomes Th or higher (YES in S17B), in S18, the service tool 200 ends the discharging of the drive battery 11.

As such, the discharging unit 211 can determine whether |ΔV/ΔQ| starts to sharply rise, based on whether |ΔV/ΔQ| has become the predetermined value or higher while the cell voltage is dropping due to the discharging. With the processes illustrated in FIG. 12, it is possible to easily determine whether |ΔV/ΔQ| starts to sharply rise while the cell voltage is dropping due to the discharging. Then, when |ΔV/ΔQ| starts to sharply rise, the discharging unit 211 can end the discharging of the cell.

FIG. 14 is a diagram illustrating a modified example of the service tool 200 illustrated in FIG. 2. With reference to FIG. 14, a service tool 200A further includes a management unit 213 and a data acquisition unit 214 in addition to the discharging unit 211 and the estimation unit 212. The management unit 213 is configured to manage V_{end}. V_{end} corresponds to the discharging end voltage indicating the timing of ending the discharging of the battery, which is executed to acquire the data for estimating the deterioration degree of the battery. The data acquisition unit 214 stores, in the management unit 213, as the discharging end voltage, the voltage of the battery when |ΔV/ΔQ| (the change degree of the voltage per unit discharging amount of the battery) has become a predetermined value (Th) or higher after the start of the discharging of the battery. The management unit 213 in the service tool 200A is embodied by a storage device 203A. The data acquisition unit 214 in the service tool 200A is embodied by the processor 201 and a diagnosis program stored in the storage device 203A.

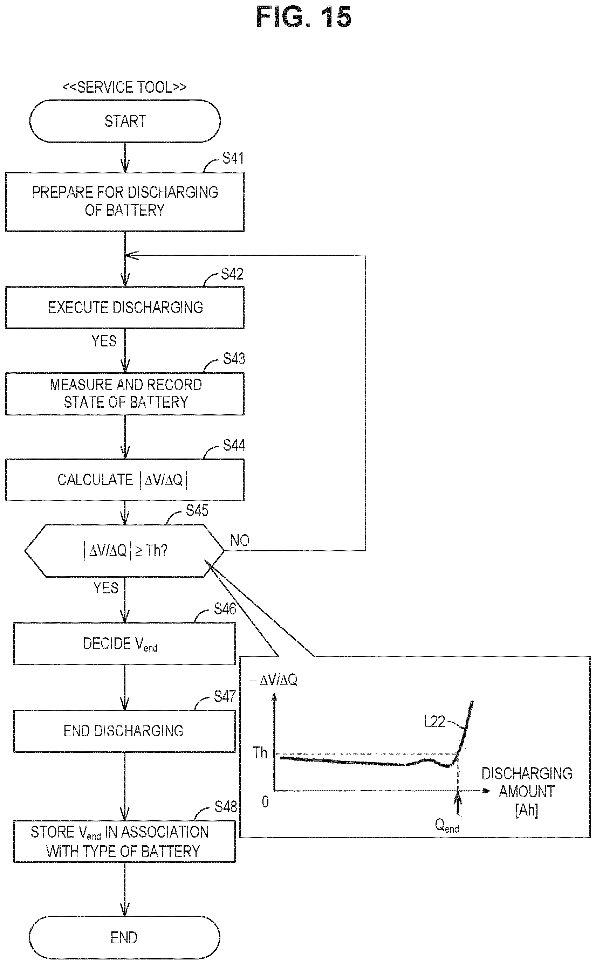

FIG. 15 is a flowchart illustrating processes related to data acquisition executed by the service tool 200A illustrated in FIG. 14. The data acquisition unit 214 of the service tool 200A transmits a control command to the HVECU 50 in a state where the vehicle 100 in an unused state (for example, before shipment) is connected to the service tool 200A, whereby S41 to S47 of FIG. 15 are executed.

With reference to FIG. 15 together with FIG. 14, in S41, the service tool 200A prepares for the discharging of the drive battery 11. In S41, the service tool 200A may execute the above-described processes of S10 to S14 of FIG. 3.

Subsequently in S42, the service tool 200A discharges the drive battery 11. The process of S42 may be equivalent to that of S16 of FIG. 3.

Subsequently in S43, the service tool 200A measures a state (a voltage, current, and a temperature) of each cell included in the drive battery 11, and records a measurement result in the storage device 203A. The process of S43 may be equivalent to that of S15 of FIG. 3.

Subsequently in S44, the service tool 200A calculates |ΔV/ΔQ| of each cell by differentiating the cell voltage with respect to the discharging amount in the transition of the voltage during the discharging of each cell included in the drive battery 11. Then, in S45, the service tool 200A determines whether |ΔV/ΔQ| of all the cells included in the drive battery 11 has become Th or higher. The processes of S44 and S45 may be equivalent to those of S17A and S17B of FIG. 12, respectively.

When |ΔV/ΔQ| of all the cells included in the drive battery 11 becomes Th or higher (YES in S45), in S46, the service tool 200A specifies a battery voltage at which |ΔV/ΔQ | starts to sharply rise while the battery voltage is dropping due to the discharging from the discharging amount (Q_{end}) when |ΔV/ΔQ| of all the cells included in the drive battery 11 has become Th or higher. Then, the service tool 200A decides the specified battery voltage to be V_{end}. V_{end} may be the voltage (for example, the average cell voltage) of the drive battery 11 when |ΔV/ΔQ| of all the cells included in the drive battery 11 has become Th or higher.

Subsequently in S47, the service tool 200A ends the discharging of the drive battery 11. The process of S47 may be equivalent to that of S18 of FIG. 3.

Subsequently in S48, the data acquisition unit 214 of the service tool 200A stores, in the management unit 213, the discharging end voltage (V_{end}) in association with information indicating the type of the battery composing the drive battery 11. The service tool 200A may acquire the information indicating the type of the battery from the vehicle 100. The information indicating the type of the battery may be stored in the storage device 53 in advance. In one example, the information indicating the type of the battery includes a battery manufacturer and a model number. The service tool 200A can discriminate, based on the battery manufacturer and the model number, the type of the battery (for example, a lithium-ion secondary battery / a nickel-hydrogen secondary battery) composing the drive battery 11. The discharging end voltage (V_{end}) may be stored in the management unit 213 by executing a series of processes illustrated in FIG. 15 to the batteries mounted on vehicles other than the vehicle 100. The management unit 213 manages a discharging end voltage (V_{end}) of a plurality of types of batteries. The management unit 213 manages the discharging end voltage (V_{end}) in association with information indicating the type of the battery in each battery. When the process of S48 is executed, the series of processes illustrated in FIG. 15 ends.

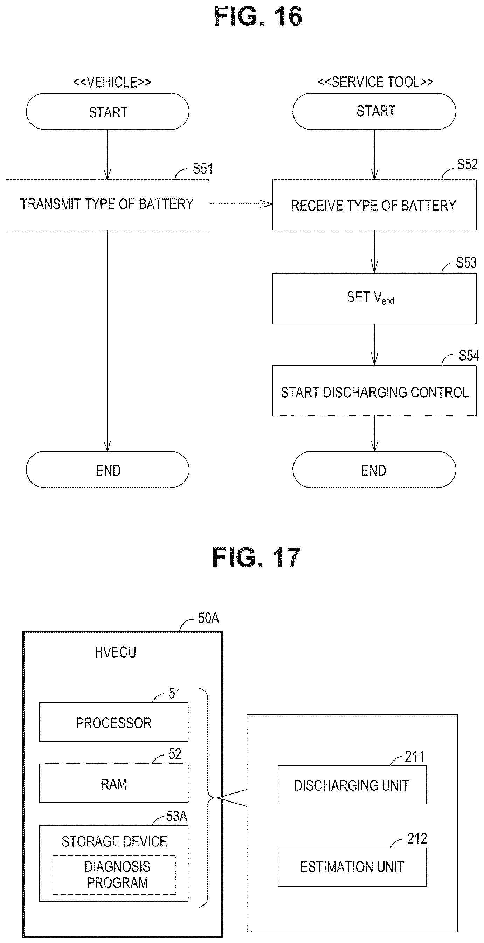

FIG. 16 is a flowchart for describing a method of setting the discharging end voltage based on the data that is acquired using the processes illustrated in FIG. 15. The processes illustrated in this flowchart are executed before the process illustrated in FIG. 3 is started. For example, when a predetermined instruction is input from the user to the HMI 204 after the service tool 200A is connected to the vehicle 100 that has been used, the processes illustrated in FIG. 16 are executed. Then, the process illustrated in FIG. 3 is started by a process of S54 described below.

With reference to FIG. 16 together with FIG. 14, in S51, the HVECU 50 transmits, to the service tool 200A, the information (for example, the battery manufacturer and the model number of the battery composing the drive battery 11) indicating the type of the battery composing the drive battery 11.

In S52, the service tool 200A receives the information indicating the type of the battery. Thereafter, the discharging unit 211 of the service tool 200A executes the processes of S53 and S54 described below.

In S53, the service tool 200A acquires, from the management unit 213, the discharging end voltage (V_{end}) corresponding to the type of the battery composing the drive battery 11 using the information indicating the type of the battery, and sets it. Thereafter, in S54, the service tool 200A generates a discharging control start trigger used for deterioration diagnosis of the assembled battery. As such, the process illustrated in FIG. 3 is started. In the processes illustrated in FIG. 3, the battery is discharged based on an appropriate discharging end voltage (that is, V_{end} set in S53) corresponding to the type of the battery mounted on the vehicle 100. As such, it is possible to estimate, with sufficient accuracy, the deterioration degree of the battery while restricting the deterioration of the cell during the discharging.

The functions of the discharging unit 211 and the estimation unit 212 may be implemented in the vehicle 100. FIG. 17 is a diagram illustrating a modified example of the HVECU 50 illustrated in FIG. 2. With reference to FIG. 17, an HVECU 50A mounted on the vehicle 100 may include the discharging unit 211 and the estimation unit 212. In such an embodiment, the HVECU 50A mounted on the vehicle 100 executes the processes illustrated in FIG. 3. The discharging unit 211 and the estimation unit 212 in the HVECU 50A may be embodied by the processor 51 and a program (for example, a diagnosis program stored in a storage device 53A) executed by the processor 51. However, each of the discharging unit 211, the estimation unit 212, and the data acquisition unit 214 that are described above may be embodied by dedicated hardware (an electronic circuit).

In the above embodiment, the assembled battery mounted on the HEV which does not include an inlet for a plug-in is a target of the deterioration diagnosis. However, the present disclosure is not limited thereto, and an assembled battery mounted on a plug-in hybrid electric vehicle (PHEV) which includes an inlet for a plug-in may be a target of the deterioration diagnosis. Further, an assembled battery mounted on other xEVs (for example, a BEV, an FCEV, a range extender EV) may be a target of the deterioration diagnosis. The xEV is a vehicle that uses power as all or part of a drive power source.

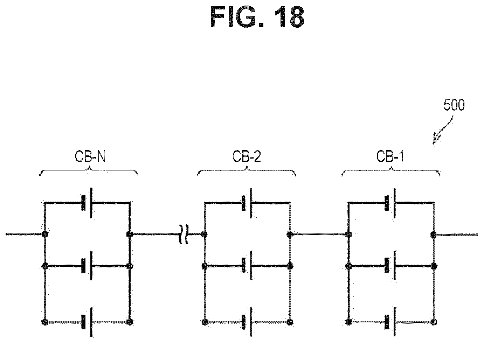

It is not essential that all the cells are connected in series in the assembled battery of which the deterioration is diagnosed by any of the above-described methods (see FIG. 2). The structure of the assembled battery of which the deterioration is diagnosed is arbitrary. FIG. 18 is a diagram illustrating a modified example of the assembled battery illustrated in FIG. 2. For example, an assembled battery 500 illustrated in FIG. 18 may be a target of the deterioration diagnosis. The assembled battery 500 includes N parallel cell blocks (that is, parallel cell blocks CB-1 to CB-N). Each of the parallel cell blocks CB-1 to CB-N includes a plurality of cells connected in parallel. The number of cells connected in parallel in each parallel cell block is arbitrary, but in the example illustrated in FIG. 18, it is three. The parallel cell blocks CB-1 to CB-N are connected in series via a power line.

The invention is defined by the appended claims.

## Claims

1. A deterioration diagnosis apparatus (200) of a battery, the deterioration diagnosis apparatus (200) comprising one or more processors (201) configured to:
execute discharging of each of a plurality of cells included in an assembled battery (11) while measuring a voltage of each of the cells;
estimate a deterioration degree of each of the cells included in the assembled battery (11) using voltage data indicating a transition of the voltage of each of the cells included in the assembled battery (11) from a discharging start voltage to a predetermined discharging end voltage (V_{end}), the predetermined discharging end voltage (V_{end}) being a cell voltage at which a change degree of the cell voltage per unit discharging amount starts to sharply rise while the cell voltage is dropping due to the discharging; and
end the discharging when voltages of all the cells included in the assembled battery (11) reach the predetermined discharging end voltage (V_{end}).

2. The deterioration diagnosis apparatus (200) according to claim 1, wherein:
each of the cells included in the assembled battery (11) is a lithium-ion secondary battery; and
the predetermined discharging end voltage (V_{end}) is higher than a voltage at which an entire lithium site in a positive electrode active material of the lithium-ion secondary battery is occupied.

3. The deterioration diagnosis apparatus (200) according to claim 1 or 2, wherein:
each of the cells included in the assembled battery (11) is a lithium-ion secondary battery having a positive electrode of a layer-shaped crystal structure expressed by a general formula of LiₓNi_{y}Co_{z}Mn_{(1 - x -z)}; and
the predetermined discharging end voltage (V_{end}) is 3.1 V or higher and 3.5 V or lower.

4. The deterioration diagnosis apparatus (200) according to claim 1 or 2, wherein:
each of the cells included in the assembled battery (11) is a lithium-ion secondary battery having a positive electrode of an olivine-shaped crystal structure expressed by a general formula of LiₓFePO₄; and
the predetermined discharging end voltage (V_{end}) is 2.0 V or higher and 3.2 V or lower.

5. The deterioration diagnosis apparatus (200) according to any one of claims 1 to 4, wherein:
the predetermined discharging end voltage (V_{end}) is a cell voltage at which the change degree of the cell voltage per unit discharging amount is a predetermined value or higher while the cell voltage is dropping due to the discharging; and
the one or more processors (201) are configured to determine whether the change degree of the cell voltage per unit discharging amount becomes the predetermined value or higher while the cell voltage is dropping due to the discharging of each cell included in the assembled battery (11), and, upon determining that the change degrees of the cell voltages per unit discharging amount of all the cells included in the assembled battery (11) become the predetermined value or higher, end the discharging.

6. The deterioration diagnosis apparatus (200) according to any one of claims 1 to 4, wherein:
the assembled battery (11) is mounted on a vehicle (100); and
the one or more processors (201) are configured to estimate the deterioration degree of the assembled battery (11) using a usage history of the vehicle (100), and change the predetermined discharging end voltage (V_{end}) such that the predetermined discharging end voltage (V_{end}) becomes higher as the estimated deterioration degree of the assembled battery (11) is higher.

7. The deterioration diagnosis apparatus (200) according to any one of claims 1 to 6, wherein:
all the cells included in the assembled battery (11) are connected in series; and
the one or more processors (201) are configured to maintain a current value during the discharging of each of the cells.

8. The deterioration diagnosis apparatus (200) according to any one of claims 1 to 7, wherein:
the assembled battery (11) is configured to supply power to an in-vehicle power load (91, 92); and
the one or more processors (201) are configured to execute the discharging by controlling the in-vehicle power load (91, 92).

9. A deterioration diagnosis apparatus (200A) of a battery, the deterioration diagnosis apparatus comprising:
a storage device (203A) configured to manage a discharging end voltage (V_{end}) indicating a timing of ending discharging of the battery, the discharging of the battery being executed to acquire data for estimating a deterioration degree of the battery, the discharging end voltage (V_{end}) being a voltage of the battery when a change degree of a voltage per unit discharging amount of the battery after a start of the discharging of the battery becomes a predetermined value or higher;
**characterized by**
one or more processors (201) configured to store, in the storage device (203A), the discharging end voltage (V_{end}) in association with information indicating the type of the battery;
the one or more processors (201) configured to acquire, from the storage device (203A), the discharging end voltage (V_{end}) corresponding to the type of the battery using the information indicating the type of the battery, and discharge the battery based on the discharging end voltage (V_{end}).

10. A deterioration diagnosis method of a battery executed by one or more processors, the deterioration diagnosis method comprising:
executing discharging of each of a plurality of cells included in an assembled battery (11) while measuring a voltage of each of the cells, and ending the discharging when voltages of all the cells included in the assembled battery (11) reach a predetermined discharging end voltage (V_{end}), the predetermined discharging end voltage (V_{end}) being a cell voltage at which a change degree of the cell voltage per unit discharging amount starts to sharply rise while the cell voltage is dropping due to the discharging; and
estimating a deterioration degree of each of the cells included in the assembled battery (11) using voltage data indicating a transition of the voltage of each of the cells included in the assembled battery (11) from a discharging start voltage to the predetermined discharging end voltage (V_{end}).

## Patentansprüche

1. Verschlechterungsdiagnosevorrichtung (200) einer Batterie, wobei die Verschlechterungsdiagnosevorrichtung (200) einen oder mehrere Prozessoren (201) aufweist, die dafür ausgelegt sind:
ein Entladen von jeder einer Mehrzahl an Zellen auszuführen, die in einer zusammengesetzten Batterie (11) enthalten sind, während eine Spannung von jeder der Zellen gemessen wird;
einen Verschlechterungsgrad von jeder der Zellen, die in der zusammengesetzten Batterie (11) enthalten sind, unter Verwendung von Spannungsdaten zu schätzen, die einen Übergang der Spannung von jeder der in der zusammengesetzten Batterie (11) enthaltenen Zellen von einer Entladungsanfangsspannung auf eine vorgegebene Entladungsendspannung (V_{end}) anzeigen, wobei die vorgegebene Entladungsendspannung (V_{end}) eine Zellspannung ist, bei der ein Änderungsgrad der Zellspannung pro Einheitsentladungsmenge stark anzusteigen beginnt, während die Zellspannung aufgrund des Entladens abfällt; und
das Entladen zu beenden, wenn Spannungen von allen in der zusammengesetzten Batterie (11) enthaltenen Zellen die vorgegebene Entladungsendspannung (V_{end}) erreichen.

2. Verschlechterungsdiagnosevorrichtung (200) nach Anspruch 1, wobei:
jede der in der zusammengesetzten Batterie (11) enthaltenen Zellen eine Lithium-Ionen-Sekundärbatterie ist; und
die vorgegebene Entladungsendspannung (V_{end}) höher ist als eine Spannung, bei der ein gesamter Lithiumbereich von einem Positivelektrodenaktivmaterial der Lithium-Ionen-Sekundärbatterie belegt ist.

3. Verschlechterungsdiagnosevorrichtung (200) nach Anspruch 1 oder 2, wobei:
jede der in der zusammengesetzten Batterie (11) enthaltenen Zellen eine Lithium-Ionen-Sekundärbatterie mit einer Positivelektrode aus einer schichtförmigen Kristallstruktur ist, die durch eine allgemeine Formel LiₓNi_{y}Co_{z}Mn_{(1-x-z)} ausgedrückt wird; und
die vorgegebene Entladungsendspannung (V_{end}) 3,1 V oder mehr und 3,5 V oder weniger beträgt.

4. Verschlechterungsdiagnosevorrichtung (200) nach Anspruch 1 oder 2, wobei:
jede der in der zusammengesetzten Batterie (11) enthaltenen Zellen eine Lithium-Ionen-Sekundärbatterie mit einer Positivelektrode aus einer olivinförmigen Kristallstruktur ist, die durch eine allgemeine Formel LiₓFePO₄ ausgedrückt wird; und
die vorgegebene Entladungsendspannung (V_{end}) 2,0 V oder mehr und 3,2 V oder weniger beträgt.

5. Verschlechterungsdiagnosevorrichtung (200) nach einem der Ansprüche 1 bis 4, wobei:
die vorgegebene Entladungsendspannung (V_{end}) eine Zellspannung ist, bei der der Änderungsgrad der Zellspannung pro Einheitsentladungsmenge ein vorgegebener Wert oder höher ist, während die Zellspannung aufgrund des Entladens abfällt; und
der eine oder die mehreren Prozessoren (201) dafür ausgelegt sind, zu bestimmen, ob der Änderungsgrad der Zellspannung pro Einheitsentladungsmenge der vorgegebene Wert oder höher wird, während die Zellspannung aufgrund des Entladens von jeder der in der zusammengesetzten Batterie (11) enthaltenen Zellen abfällt, und das Entladen zu beenden, wenn bestimmt wird, dass der Änderungsgrad der Zellspannungen pro Einheitsentladungsmenge aller in der zusammengesetzten Batterie (11) enthaltenen Zellen der vorgegebene Wert oder höher wird.

6. Verschlechterungsdiagnosevorrichtung (200) nach einem der Ansprüche 1 bis 4, wobei:
die zusammengesetzte Batterie (11) an einem Fahrzeug (100) montiert ist; und
der eine oder die mehreren Prozessoren (201) dafür ausgelegt sind, den Verschlechterungsgrad der zusammengesetzten Batterie (11) unter Verwendung einer Verwendungshistorie des Fahrzeugs (100) zu schätzen und die vorgegebene Entladungsendspannung (V_{end}) so zu ändern, dass die vorgegebene Entladungsendspannung (V_{end}) in dem Maße höher wird, in dem der geschätzte Verschlechterungsgrad der zusammengesetzten Batterie (11) höher wird.

7. Verschlechterungsdiagnosevorrichtung (200) nach einem der Ansprüche 1 bis 6, wobei:
alle in der zusammengesetzten Batterie (11) enthaltenen Zellen in Reihe verbunden sind; und
der eine oder die mehreren Prozessoren (201) dafür ausgelegt sind, einen Stromwert während des Entladens von jeder der Zellen beizubehalten.

8. Verschlechterungsdiagnosevorrichtung (200) nach einem der Ansprüche 1 bis 7, wobei:
die zusammengesetzte Batterie (11) dafür ausgelegt ist, einer sich im Fahrzeug befindlichen Stromlast (91, 92) Strom zuzuführen; und
der eine oder die mehreren Prozessoren (201) dafür ausgelegt sind, das Entladen durch Steuern der sich im Fahrzeug befindlichen Stromlast (91, 92) auszuführen.

9. Verschlechterungsdiagnosevorrichtung (200A) einer Batterie, wobei die Verschlechterungsdiagnosevorrichtung aufweist:
eine Speichervorrichtung (203A), die dafür ausgelegt ist, eine Entladungsendspannung (V_{end}) zu verwalten, die einen Zeitpunkt des Endes eines Entladens der Batterie anzeigt, wobei das Entladen der Batterie ausgeführt wird, um Daten zum Schätzen eines Verschlechterungsgrads der Batterie zu erhalten, wobei die Entladungsendspannung (V_{end}) eine Spannung der Batterie ist, wenn ein Änderungsgrad einer Spannung pro Einheitsentladungsmenge der Batterie nach einem Beginn des Entladens der Batterie ein vorgegebener Wert oder höher wird;
**gekennzeichnet durch**:
einen oder mehrere Prozessoren (201), die dafür ausgelegt sind, in der Speichervorrichtung (203A) die Entladungsendspannung (V_{end}) zusammen mit Informationen, die den Batterietyp anzeigen, zu speichern;
wobei der eine oder die mehreren Prozessoren (201) dafür ausgelegt sind, unter Verwendung der Informationen, die den Batterietyp anzeigen, von der Speichervorrichtung (203A) die Entladungsendspannung (V_{end}) zu erhalten, die dem Batterietyp entspricht, und die Batterie auf Basis der Entladungsendspannung (V_{end}) zu entladen.

10. Verschlechterungsdiagnoseverfahren einer Batterie, das durch einen oder mehrere Prozessoren ausgeführt wird, wobei das Verschlechterungsdiagnoseverfahren aufweist:
Ausführen eines Entladens von jeder einer Mehrzahl an in einer zusammengesetzten Batterie (11) enthaltenen Zellen, während eine Spannung von jeder der Zellen gemessen wird, und Beenden des Entladens, wenn Spannungen von allen in der zusammengesetzten Batterie (11) enthaltenen Zellen eine vorgegebene Entladungsendspannung (V_{end}) erreichen, wobei die vorgegebene Entladungsendspannung (V_{end}) eine Zellspannung ist, bei der ein Änderungsgrad der Zellspannung pro Einheitsentladungsmenge stark zu steigen beginnt, während die Zellspannung aufgrund des Entladens abfällt; und
Schätzen eines Verschlechterungsgrads von jeder der in der zusammengesetzten Batterie (11) enthaltenen Zellen unter Verwendung von Spannungsdaten, die einen Übergang der Spannung von jeder der in der zusammengesetzten Batterie (11) enthaltenen Zellen von einer Entladungsanfangsspannung auf die vorgegebene Entladungsendspannung (V_{end}) anzeigen.

## Revendications

1. Appareil de diagnostic de détérioration (200) d'une batterie, l'appareil de diagnostic de détérioration (200) comprenant un ou plusieurs processeurs (201) configurés pour :
exécuter la décharge de chacune d'une pluralité de cellules incluses dans une batterie assemblée (11) tout en mesurant la tension de chacune des cellules ;
estimer un degré de détérioration de chacune des cellules incluses dans la batterie assemblée (11) à l'aide de données de tension indiquant une transition de la tension de chacune des cellules incluses dans la batterie assemblée (11) d'une tension de début de décharge à une tension de fin de décharge prédéterminée (V_{end}), la tension de fin de décharge prédéterminée (V_{end}) étant une tension de cellule à laquelle un degré de changement de la tension de cellule par unité de quantité de décharge commence à augmenter brusquement alors que la tension de cellule diminue en raison de la décharge ; et
mettre fin à la décharge lorsque les tensions de toutes les cellules incluses dans la batterie assemblée (11) atteignent la tension de fin de décharge prédéterminée (V_{end}).

2. L'appareil de diagnostic de détérioration (200) selon la revendication 1, dans lequel :
chacune des cellules incluses dans la batterie assemblée (11) est une batterie secondaire au lithium-ion ; et
la tension de fin de décharge prédéterminée (V_{end}) est supérieure à une tension à laquelle un site entier de lithium dans un matériau actif d'électrode positive de la batterie secondaire lithium-ion est occupé.

3. L'appareil de diagnostic de détérioration (200) selon la revendication 1 ou 2, dans lequel :
chacune des cellules incluses dans la batterie assemblée (11) est une batterie secondaire au lithium-ion ayant une électrode positive d'une structure cristalline en forme de couche exprimée par une formule générale de LiₓNi_{y}Co_{z}Mn_{(1 - x - z)}; et
la tension de fin de décharge prédéterminée (V_{end}) est supérieure ou égale à 3,1 V et inférieure ou égale à 3,5 V.

4. L'appareil de diagnostic de détérioration (200) selon la revendication 1 ou 2, dans lequel :
chacune des cellules incluses dans la batterie assemblée (11) est une batterie secondaire au lithium-ion dont l'électrode positive a une structure cristalline en forme d'olivine exprimée par une formule générale de LiₓFePO₄; et
la tension de fin de décharge prédéterminée (V_{end}) est égale ou supérieure à 2,0 V et inférieure ou égale à 3,2 V.

5. L'appareil de diagnostic de détérioration (200) selon l'une des revendications 1 à 4, dans lequel :
la tension de fin de décharge prédéterminée (V_{end}) est une tension de cellule à laquelle le degré de changement de la tension de cellule par unité de quantité de décharge est une valeur prédéterminée ou plus élevée alors que la tension de cellule diminue en raison de la décharge ; et
un ou plusieurs processeurs (201) sont configurés pour déterminer si le degré de variation de la tension de cellule par unité de quantité de décharge devient la valeur prédéterminée ou plus élevée alors que la tension de cellule diminue en raison de la décharge de chaque cellule incluse dans la batterie assemblée (11), et, après avoir déterminé que les degrés de variation des tensions de cellule par unité de quantité de décharge de toutes les cellules incluses dans la batterie assemblée (11) deviennent la valeur prédéterminée ou plus élevée, mettre fin à la décharge.

6. L'appareil de diagnostic de détérioration (200) selon l'une des revendications 1 à 4, dans lequel :
la batterie assemblée (11) est montée sur un véhicule (100) ; et
le ou les processeurs (201) sont configurés pour estimer le degré de détérioration de la batterie assemblée (11) en utilisant un historique d'utilisation du véhicule (100), et modifier la tension de fin de décharge prédéterminée (V_{end}) de sorte que la tension de fin de décharge prédéterminée (V_{end}) devienne plus élevée lorsque le degré de détérioration estimé de la batterie assemblée (11) est plus élevé.

7. L'appareil de diagnostic de détérioration (200) selon l'une des revendications 1 à 6, dans lequel :
toutes les cellules incluses dans la batterie assemblée (11) sont connectées en série ; et
le ou les processeurs (201) sont configurés pour maintenir une valeur de courant pendant la décharge de chacune des cellules.

8. L'appareil de diagnostic de détérioration (200) selon l'une des revendications 1 à 7, dans lequel :
la batterie assemblée (11) est configurée pour fournir de l'énergie à une charge électrique dans un véhicule (91, 92) ; et
le ou les processeurs (201) sont configurés pour exécuter la décharge en contrôlant la charge électrique dans un véhicule (91, 92).

9. Appareil de diagnostic de détérioration (200A) d'une batterie, l'appareil de diagnostic de détérioration comprenant :
un dispositif de stockage (203A) configuré pour gérer une tension de fin de décharge (V_{end}) indiquant un moment de fin de décharge de la batterie, la décharge de la batterie étant exécutée pour acquérir des données permettant d'estimer un degré de détérioration de la batterie, la tension de fin de décharge (V_{end}) étant une tension de la batterie lorsqu'un degré de changement d'une tension par unité de quantité de décharge de la batterie après le début de la décharge de la batterie devient une valeur prédéterminée ou plus élevée ;
**caractérisé par**
un ou plusieurs processeurs (201) configurés pour stocker, dans le dispositif de stockage (203A), la tension de fin de décharge (V_{end}) en association avec des informations indiquant le type de la batterie ;
un ou plusieurs processeurs (201) configurés pour acquérir, à partir du dispositif de stockage (203A), la tension de fin de décharge (V_{end}) correspondant au type de la batterie en utilisant l'information indiquant le type de la batterie, et décharger la batterie sur la base de la tension de fin de décharge (V_{end}).

10. Méthode de diagnostic de la détérioration d'une batterie exécutée par un ou plusieurs processeurs, la méthode de diagnostic de la détérioration comprenant :
exécuter la décharge de chacune d'une pluralité de cellules incluses dans une batterie assemblée (11) tout en mesurant une tension de chacune des cellules, et mettre fin à la décharge lorsque les tensions de toutes les cellules incluses dans la batterie assemblée (11) atteignent une tension de fin de décharge prédéterminée (V_{end}), la tension de fin de décharge prédéterminée (V_{end}) étant une tension de cellule à laquelle un degré de changement de la tension de cellule par unité de quantité de décharge commence à augmenter brusquement alors que la tension de la cellule diminue en raison de la décharge ; et
estimer un degré de détérioration de chacune des cellules incluses dans la batterie assemblée (11) en utilisant des données de tension indiquant une transition de la tension de chacune des cellules incluses dans la batterie assemblée (11) d'une tension de début de décharge à la tension de fin de décharge prédéterminée (V_{end}).
